# EUROPEAN PATENT APPLICATION

(11) **EP 4 415 497 A2**
(43) Date of publication of application: **14.08.2024**
(21) Application number: 23205348.8
(22) Date of filing: 23.10.2023
(51) Int. Cl.: H10B 12/00, H01L 29/786

(54) **SEMICONDUCTOR MEMORY DEVICE**

(30) Priority: 09.02.2023 KR 20230017260
(71) Applicant: Samsung Electronics Co., Ltd., Suwon-si, Gyeonggi-do 16677 (KR)
(72) Inventor: LEE, Wonsok, 16677 Suwon-si (KR); LEE, Juho, 16677 Suwon-si (KR); KIM, Seunghyun, 16677 Suwon-si (KR); JUNG, Wooje, 16677 Suwon-si (KR); CHO, Minhee, 16677 Suwon-si (KR)
(74) Representative: Marks & Clerk LLP

(57) **Abstract**

A semiconductor memory device, which may include a substrate, a lower conductive line on the substrate, an isolation insulating layer on the lower conductive line and including a channel trench, a channel structure inside the channel trench and including a first oxide semiconductor material, an interfacial conductive pattern between the lower conductive line and a lower surface of the channel structure, a gate dielectric layer that covers the channel structure within the channel trench, an upper conductive line on the gate dielectric layer within the channel trench, a conductive contact pattern on the channel structure, an interfacial oxide semiconductor pattern between the channel structure and the conductive contact pattern and including a second oxide semiconductor material, and a capacitor structure including a lower electrode connected to the conductive contact pattern.

## Description

### TECHNICAL FIELD

The present disclosure relates to semiconductor memory devices, and more particularly, to semiconductor memory devices including channel structures.

### BACKGROUND

With the development of electronics technology, down-scaling of semiconductor devices is rapidly progressing and accordingly, a transistor having a channel layer using an oxide semiconductor material to reduce leakage current through the channel region has been proposed.

### SUMMARY

The inventive concepts of the present disclosure provide semiconductor memory devices with improved reliability.

According to some aspects of the inventive concepts, there is provided a semiconductor memory device which may include a substrate, a lower conductive line on the substrate, an isolation insulating layer on the lower conductive line and including a channel trench, a channel structure inside the channel trench and including a first oxide semiconductor material, an interfacial conductive pattern between the lower conductive line and a lower surface of the channel structure, a gate dielectric layer that covers the channel structure within the channel trench, an upper conductive line on the gate dielectric layer within the channel trench, a conductive contact pattern on the channel structure, an interfacial oxide semiconductor pattern between the channel structure and the conductive contact pattern and including a second oxide semiconductor material, and a capacitor structure including a lower electrode connected to the conductive contact pattern. The contact area between the interfacial conductive pattern and the channel structure may be greater than the contact area between the interfacial conductive pattern and the lower conductive line, and the contact area between the interfacial oxide semiconductor pattern and the conductive contact pattern may be greater than the contact area between the interfacial oxide semiconductor pattern and the channel structure.

According to some aspects of the inventive concepts, there is provided a semiconductor memory device which may include a substrate, a conductive line on the substrate and extending in a first direction, an interfacial conductive pattern extending in the first direction on the conductive line, and a channel structure on the interfacial conductive pattern and including an oxide semiconductor material. The contact area between the interfacial conductive pattern and the channel structure may be greater than the contact area between the interfacial conductive pattern and the conductive line.

According to some aspects of the inventive concepts, there is provided a semiconductor memory device which may include a substrate, a lower conductive line on the substrate, a channel structure on the lower conductive line and including a first oxide semiconductor material, a conductive contact pattern on the channel structure, an interfacial oxide semiconductor pattern between the channel structure and the conductive contact pattern and including a second oxide semiconductor material, and a capacitor structure including a lower electrode connected to the conductive contact pattern. The contact area between the interfacial oxide semiconductor pattern and the conductive contact pattern may be greater than the contact area between the interfacial oxide semiconductor pattern and the channel structure.

At least some of the above and other features of the invention are set out in the claims.

### BRIEF DESCRIPTION OF THE DRAWINGS

Some examples of embodiments of the present inventive concepts will be understood more clearly from the following detailed description taken in conjunction with the accompanying drawings in which:
FIG. 1 is a planar layout diagram showing a configuration of a semiconductor memory device according to some embodiments;
FIG. 2A is a cross-sectional view taken along line A-A' of FIG. 1;
FIG. 2B is a cross-sectional view taken along line B-B' of FIG. 1;
FIGS. 3A to 17B are cross-sectional views for describing a method of fabricating a semiconductor memory device, according to some embodiments, with FIGS. 3A, 4A, 5A, 6A, 7A, 8A, 9A, 10A, 11A, 12A, 13A, 14A, 15A, 16A, and 17A being cross-sectional views taken along line A-A' of FIG. 1, and FIGS. 3B, 4B, 5B, 6B, 7B, 8B, 9B, 10B, 11B, 12B, 13B, 14B, 15B, 16B, and 17B being cross-sectional views taken along line B-B' of FIG. 1;
FIG. 18 is a cross-sectional view illustrating a semiconductor memory device according to some embodiments; and
FIG. 19 is a cross-sectional view illustrating a semiconductor memory device according to some embodiments.

### DETAILED DESCRIPTION OF THE EMBODIMENTS

Hereinafter, some examples of embodiments will be described in detail with reference to the accompanying drawings. The same reference numerals are used for the same components in the drawings, and redundant descriptions thereof will be omitted herein in the interest of brevity.

In the present specification, a vertical direction may be defined as a Z direction, and a horizontal direction may be defined as a direction perpendicular to the Z direction. A first horizontal direction and a second horizontal direction may be defined as directions intersecting with each other. The first horizontal direction may be perpendicular to the second horizontal direction. The first horizontal direction may be referred to as an X direction, and the second horizontal direction may be referred to as a Y direction. An X-Y plane may be defined as a plane perpendicular to the Z direction, and a Y-Z plane may be defined as a plane perpendicular to the X direction. A vertical level may refer to a height in the vertical direction.

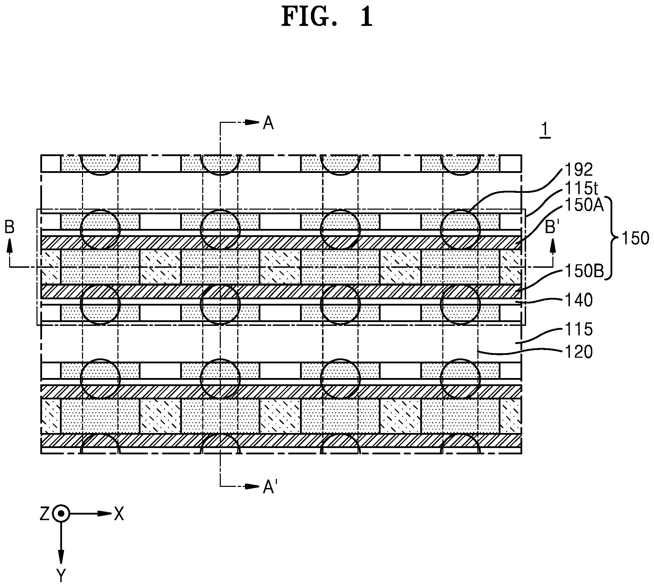

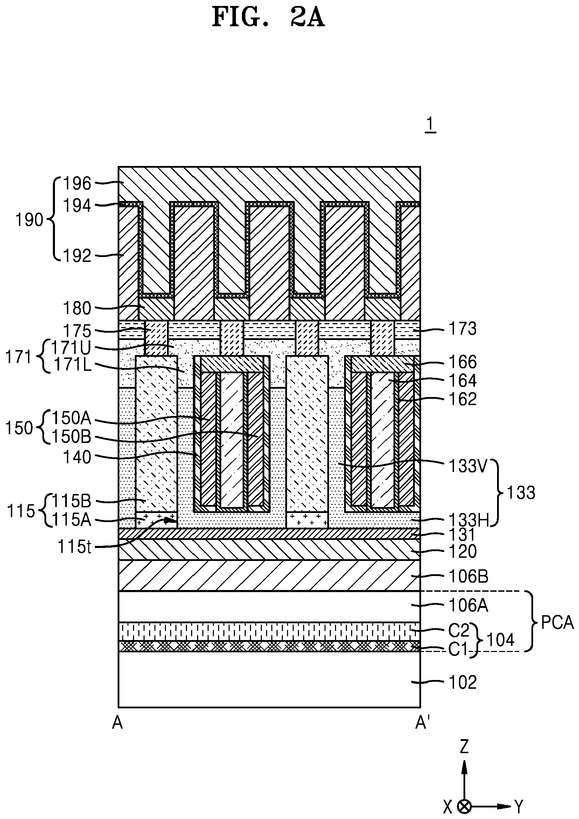

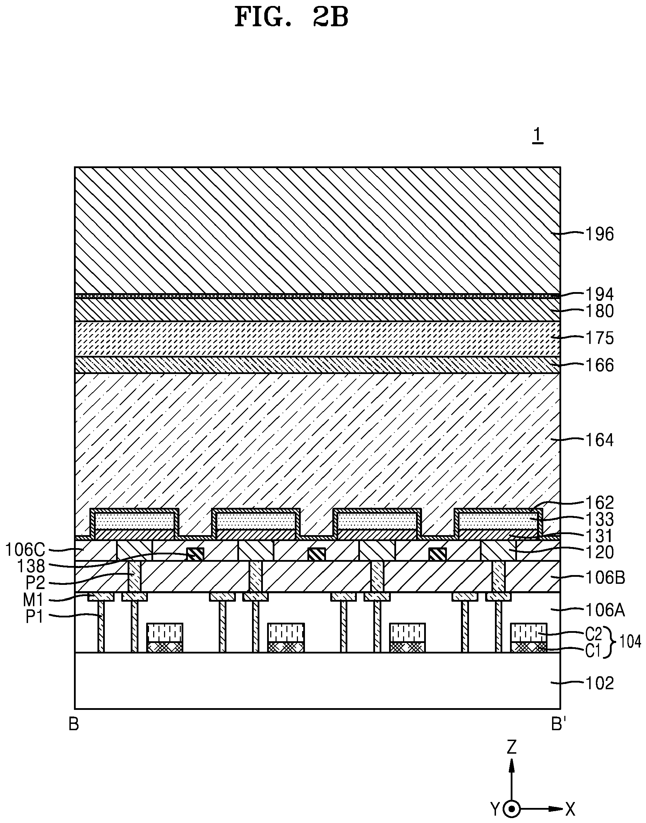

FIG. 1 is a planar layout diagram showing a configuration of a semiconductor memory device 1 according to some embodiments. FIG. 2A is a cross-sectional view taken along line A-A' of FIG. 1, and FIG. 2B is a cross-sectional view taken along line B-B' of FIG. 1.

Referring to FIGS. 1, 2A, and 2B, the semiconductor memory device 1 may include a substrate 102, a peripheral circuit structure PCA arranged on the substrate 102 and including a plurality of peripheral circuits, a plurality of conductive lines 120, and a plurality of shielding structures 138. The plurality of conductive lines 120 and the plurality of shielding structures 138 may be arranged above the peripheral circuit structure PCA. Each conductive line 120 may correspond to a bit line of the semiconductor memory device 1. In the present specification, each conductive line 120 may be referred to as a lower conductive line.

In some embodiments, the substrate 102 may include silicon, for example, monocrystalline silicon, polycrystalline silicon, or amorphous silicon. In some embodiments, the substrate 102 may include at least one selected from Ge, SiGe, SiC, GaAs, InAs, and/or InP. In some embodiments, the substrate 102 may include a conductive region, for example, a well doped with impurities or a structure doped with impurities.

Each of the plurality of conductive lines 120 may be connected to at least one peripheral circuit among the plurality of peripheral circuits included in the peripheral circuit structure PCA. Each of the plurality of shielding structures 138 may be floating and not connected to a peripheral circuit. The plurality of conductive lines 120 and the plurality of shielding structures 138 may be insulated from each other by an interlayer insulating film 106C. The plurality of shielding structures 138 may be covered with the interlayer insulating film 106C, and the plurality of conductive lines 120 may penetrate or extend through the interlayer insulating film 106C in the vertical direction (Z direction). The plurality of conductive lines 120 may be connected to the peripheral circuits included in the peripheral circuit structure PCA through a plurality of conductive plugs P1 and P2 and a wiring layer M1 included in the peripheral circuit structure PCA.

The peripheral circuit structure PCA may include a plurality of core circuits 104. The plurality of core circuits 104 may include a first conductive pattern C1 and a second conductive pattern C2 sequentially arranged on the substrate 102. The first conductive pattern C1 and the second conductive pattern C2 may constitute various circuit elements for controlling or configured to control functions of semiconductor elements arranged on the peripheral circuit structure PCA. In some embodiments, the peripheral circuit structure PCA may further include various active elements, such as transistors, and various passive elements, such as capacitors, resistors, and inductors.

In embodiments, the plurality of peripheral circuits included in the peripheral circuit structure PCA may include a sub-word line driver block, a sense amplifier block, and/or control logic, but the present disclosure is not limited thereto. The plurality of peripheral circuits included in the peripheral circuit structure PCA may include an n-channel metal-oxide semiconductor (NMOS) transistor and a p-channel metal-oxide semiconductor (PMOS) transistor. The plurality of peripheral circuits may be electrically connected to conductive lines (e.g., bit lines or conductive lines 120) arranged on the peripheral circuit structure PCA through the plurality of conductive plugs P1 and P2 and the wiring layer M1.

In the peripheral circuit structure PCA, components which are to be insulated from each other, among the plurality of core circuits 104, the plurality of conductive plugs P1 and P2, and the wiring layer M1, may maintain appropriate and/or required insulation distances by a plurality of interlayer insulating films 106A, 106B, and 106C. Each of the plurality of interlayer insulating films 106A, 106B, and 106C may be formed of an oxide film, a nitride film, or a combination thereof, but the present disclosure is not limited thereto.

In some embodiments, the peripheral circuit structure PCA on the substrate 102 may be omitted. In this case, the peripheral circuit structure PCA may be arranged in another region on the substrate 102 and may be spaced apart from the regions illustrated in FIGS. 2A and 2B. In some embodiments, the peripheral circuit structure PCA may be arranged in another region laterally spaced apart from a cell array region.

The plurality of conductive lines 120 and the plurality of shielding structures 138 may be spaced apart from each other in the first horizontal direction (X direction) on the substrate 102, and may extend in the second horizontal direction (Y direction). The plurality of conductive lines 120 and the plurality of shielding structures 138 may extend in parallel to each other in the second horizontal direction (Y direction). In embodiments, each conductive line 120 may be formed of Ti, TiN, Ta, TaN, Mo, Ru, W, WN, Co, La, Pd, Ni, TiSi, TiSiN, WSi, WSiN, TaSi, TaSiN, RuTiN, CoSi, NiSi, ITO (InSnO), or polysilicon, or a combination of two or more thereof, but the present disclosure is not limited thereto. In some embodiments, each of the plurality of shielding structures 138 may be formed of W, Al, or Cu, or a combination of two or more thereof, but the present disclosure is not limited thereto. In some embodiments, each of the plurality of shielding structures 138 may include a conductive film and an air gap or a void inside the conductive film, wherein the conductive film is formed of W, Al, or Cu, or a combination of two or more thereof.

An isolation insulating layer 115 may be arranged above the plurality of conductive lines 120 and the plurality of shielding structures 138. For example, the isolation insulating layer 115 may be arranged on a plurality of interfacial conductive patterns 131 provided on the plurality of conductive lines 120. In some embodiments, the lower surface of the isolation insulating layer 115 may be in contact (e.g., direct contact) with the upper surface of each interfacial conductive pattern 131.

The isolation insulating layer 115 may have a plurality of channel trenches 115t extending in the first horizontal direction (X direction). Each of the plurality of channel trenches 115t may define a transistor region in which a channel structure 133 is accommodated. In embodiments, the horizontal width of the channel trench 115t may be several nm to several tens of nm. For example, the horizontal width of the channel trench 115t may be about 10 nm. The channel trench 115t may extend from the upper surface to the lower surface of the isolation insulating layer 115. The channel trench 115t may expose at least a portion of the corresponding interfacial conductive pattern 131. For example, the upper surface of the interfacial conductive pattern 131 may be exposed under the channel trench 115t.

The isolation insulating layer 115 may include, for example, at least one of silicon oxide, silicon oxynitride, silicon nitride, and/or a low-k material having a dielectric constant less than that of silicon oxide, but the present disclosure is not limited thereto. In some embodiments, the isolation insulating layer 115 may have a stack structure of a lower isolation insulating layer 115A and an upper isolation insulating layer 115B. In embodiments, the lower isolation insulating layer 115A may be formed of a nitride and the upper isolation insulating layer 115B may be formed of an oxide.

A plurality of the channel structures 133 may be provided inside the plurality of channel trenches 115t of the isolation insulating layer 115. The plurality of channel structures 133 may be arranged on the corresponding conductive lines 120, respectively. The plurality of channel structures 133 may be spaced apart from each other in the first horizontal direction (X direction) and the second horizontal direction (Y direction) and may be arranged in a matrix form. The lower surface of each channel structure 133 may face the upper surface of the conductive line 120, and the uppermost surface of each channel structure 133 may be at a vertical level lower than the vertical level of the upper surface of the isolation insulating layer 115.

Each channel structure 133 may include a vertical channel portion 133V facing a sidewall of the isolation insulating layer 115 (i.e., the sidewall of the isolation insulating layer 115 defining the channel trench 115t) and each channel structure 133 may include a horizontal channel portion 133H facing the upper surface of the conductive line 120. In each channel structure 133, the horizontal channel portion 133H may be in direct contact with the interfacial conductive pattern 131 and continuously extend in the first horizontal direction (X direction) along the upper surface of the interfacial conductive pattern 131. In each channel structure 133, the vertical channel portion 133V may be in contact (and may be in direct contact) with the sidewall of the isolation insulating layer 115 and extend in the vertical direction (Z direction) from the horizontal channel portion 133H along the sidewall of the isolation insulating layer 115. In each channel structure 133, the lower surface of the vertical channel portion 133V may be arranged on the horizontal channel portion 133H, and the upper surface of the vertical channel portion 133V may be at a vertical level lower than the vertical level of the upper surface of the isolation insulating layer 115. Each channel structure 133 may include one horizontal channel portion 133H, the vertical channel portion 133V connected to a first side of the horizontal channel portion 133H, and the vertical channel portion 133V connected to a second side of the horizontal channel portion 133H that is opposite from the first side. As illustrated in the cross-sectional view of FIG. 2A, each channel structure 133 may have a U-shaped vertical cross-section. That is, each channel structure 133 may have a U-shape on a Y-Z plane.

In embodiments, each channel structure 133 may include a first oxide semiconductor material having a first composition. The first oxide semiconductor material may include indium gallium zinc oxide IGZO (InGaZnO), tin-doped indium gallium zinc oxide (Sn-IGZO), indium tin oxide ITO (InSnO), indium tungsten oxide IWO (InWO), indium zinc oxide IZO (InZnO), indium gallium oxide IGO (InGaO), indium tin gallium oxide ITGO (InSnGaO), zinc tin oxide ZTO (ZnSnO), ZnO, yttrium-doped zinc oxide (YZO), indium gallium silicon oxide IGSO (InGaSiO), InO, SnO, TiO, ZnON, MgZnO, ZrInZnO, HfInZnO, SnInZnO, SiInZnO, GaZnSnO, or ZrZnSnO, or a combination of two or more such materials. For example, each channel structure 133 may be formed of IGZO.

The plurality of interfacial conductive patterns 131 may be between the conductive lines 120 and the channel structures 133. The plurality of interfacial conductive patterns 131 may be spaced apart from each other in the first horizontal direction (X direction), and each interfacial conductive pattern 131 may extend in the second horizontal direction (Y direction). Each interfacial conductive pattern 131 may extend in the second horizontal direction (Y direction) along the corresponding conductive line 120 and may cover the corresponding conductive line 120. The plurality of channel structures 133 arranged in the second horizontal direction (Y direction) may be arranged on the interfacial conductive patterns 131, respectively. The conductive lines 120 may be connected to the channel structures 133 through the corresponding interfacial conductive patterns 131, respectively. The lower surface of each interfacial conductive pattern 131 may be in direct contact with the upper surface of the corresponding conductive line 120, and the upper surface of each interfacial conductive pattern 131 may be in direct contact with the lower surface of the corresponding channel structure 133. As illustrated in the cross-sectional view of FIG. 2B, each interfacial conductive pattern 131 may have a substantially rectangular shape. The thickness of each interfacial conductive pattern 131 in the vertical direction (Z direction) may range from several nm to several tens of nm.

Each interfacial conductive pattern 131 may be formed of Ti, TiN, Ta, TaN, Mo, Ru, W, WN, Co, La, Pd, Ni, TiSi, TiSiN, WSi, WSiN, TaSi, TaSiN, RuTiN, CoSi, NiSi, indium tin oxide ITO (InSnO), or polysilicon, or a combination of two or more thereof, but the present disclosure is not limited thereto. In some embodiments, the material of the interfacial conductive pattern 131 may be the same as that of the conductive line 120. For example, the interfacial conductive pattern 131 and the conductive line 120 may include the same metal. In some embodiments, the material of the interfacial conductive pattern 131 may be different from that of the conductive line 120.

In some embodiments, the width of the interfacial conductive pattern 131 in the first horizontal direction (X direction) may be greater than the width of the conductive line 120 in the first horizontal direction (X direction). For example, as illustrated in the cross-sectional view of FIG. 2B, a portion of the lower surface of the interfacial conductive pattern 131 may be in contact with the corresponding conductive line 120, and other portion(s) of the lower surface of the interfacial conductive pattern 131 may be in contact with the interlayer insulating film 106C.

In some embodiments, the width of the interfacial conductive pattern 131 in the first horizontal direction (X direction) may be substantially equal to the width of the corresponding channel structure 133 in the first horizontal direction (X direction) (i.e., the width of the horizontal channel portion 133H in the first horizontal direction (X direction)). For example, as illustrated in the cross-sectional view of FIG. 2B, the entire upper surface of the interfacial conductive pattern 131 may be in contact with and covered by the lower surface of the corresponding channel structure 133. For example, as illustrated in the cross-sectional view of FIG. 2B, the side surface of the interfacial conductive pattern 131 may be aligned with the lower side surface of the corresponding channel structure 133 in the vertical direction (Z direction). For example, as illustrated in the cross-sectional view of FIG. 2B, the side surface of the interfacial conductive pattern 131 and the side surface of the channel structure 133 may be covered by a barrier insulating layer 162, discussed in greater detail below.

The contact area between the interfacial conductive pattern 131 and the channel structure 133 (that is, the contact area between the upper surface of the interfacial conductive pattern 131 and the lower surface of the channel structure 133) may be greater than the contact area between the interfacial conductive pattern 131 and the conductive line 120 (that is, the contact area between the lower surface of the interfacial conductive pattern 131 and the upper surface of the conductive line 120).

In some embodiments, each conductive line 120 and a interfacial conductive pattern 131 in contact therewith may constitute a bit line structure, and may function as a bit line of the semiconductor memory device 1. The contact resistance between the channel structure 133 and a bit line is a factor that affects electrical characteristics of a transistor that includes the channel structure 133. The contact area formed by the contact between the channel structure 133 and the interfacial conductive pattern 131 is greater than the contact area formed by the contact between the channel structure 133 and the conductive line 120. Because the contact area between the channel structure 133 and the bit line is expanded by the interfacial conductive pattern 131, the contact resistance between the channel structure 133 containing an oxide semiconductor material and the bit line may be reduced and ultimately, the reliability of the transistor including the channel structure 133 and the reliability of the semiconductor memory device 1 may be improved.

The semiconductor memory device 1 may include a vertical channel transistor (VCT). The VCT may refer to a structure in which a channel length of a channel layer, for example, the channel structure 133, extends in the vertical direction (Z direction) perpendicular to the upper surface of the substrate 102. For example, the channel structure 133 may include a first source/drain region and a second source/drain region, which are arranged in the vertical direction (Z direction). For example, a lower portion of the channel structure 133 may include the first source/drain region, an upper portion of the channel structure 133 may include the second source/drain region, and the channel structure 133 may include a channel region between the first source/drain region and the second source/drain region.

A gate dielectric layer 140 may extend along the surface of the channel structure 133 provided in the channel trench 115t. The gate dielectric layer 140 may be between the channel structure 133 and a word line 150. In some embodiments, the top of the gate dielectric layer 140 may be at a higher vertical level than the top of the word line 150. The gate dielectric layer 140 may extend along the upper surface of the horizontal channel portion 133H and one side surface of the vertical channel portion 133V that faces a gap-fill insulating layer 164 (described in greater detail below). For example, two gate dielectric layers 140 having an L-shaped vertical cross-section and spaced apart from each other may be arranged facing each other along the inner surface of one channel structure 133, forming a U-shaped vertical cross-section. The gate dielectric layer 140 may extend in the vertical direction (Z direction) from the lower portion thereof in contact with the horizontal channel portion 133H, and the top of the gate dielectric layer 140 may be at a vertical level higher than the vertical level of the upper surface of the vertical channel portion 133V. The gate dielectric layer 140 may include, for example, at least one of silicon oxide, silicon oxynitride, silicon nitride, and/or a high-k material having a higher dielectric constant than that of silicon oxide, but the present disclosure is not limited thereto.

The word line 150 may be provided on the gate dielectric layer 140 provided in the channel trench 115t. The word line 150 may extend in the vertical direction (Z direction) along the gate dielectric layer 140 provided in the channel trench 115t. The word line 150 may extend in the first horizontal direction (X direction). The word line 150 may include doped polysilicon, a metal, a conductive metal nitride, a conductive metal silicide, or a conductive metal oxide, or a combination of two or more thereof. For example, the word line 150 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, or RuOₓ, or a combination of two or more thereof, but the present disclosure is not limited thereto.

In embodiments, the word line 150 may include a first word line 150A and a second word line 150B opposite to each other within one channel trench 115t. The first word line 150A and the second word line 150B may be spaced apart from each other in the second horizontal direction (Y direction), and the first word line 150A and the second word line 150B may extend in the first horizontal direction (X direction). Within one channel trench 115t, the channel structure 133 and the first word line 150A may be spaced apart from each other by a first gate dielectric layer 140, and the channel structure 133 and the second word line 150B may be spaced apart from each other by a second gate dielectric layer 140. The first gate dielectric layer 140 arranged between the channel structure 133 and the first word line 150A and the second gate dielectric layer 140 arranged between the channel structure 133 and the second word line 150B may each have an L-shaped vertical cross-section and be spaced apart facing each other (e.g., the second gate dielectric layer 140 may have a backwards L-shaped vertical cross section). In this case, a structure of two transistors per one channel structure 133 may be implemented. In the present specification, each word line 150 may be referred to as an upper conductive line. In addition, the first word line 150A may be referred to as a first upper conductive line and the second word line 150B may be referred to as a second upper conductive line.

In some embodiments, the barrier insulating layer 162 and the gap-fill insulating layer 164 may be provided between the first word line 150A and the second word line 150B. The first word line 150A and the second word line 150B may be separated from each other by the barrier insulating layer 162 and the gap-fill insulating layer 164. The barrier insulating layer 162 may extend, for example, along the inner surface of the first word line 150A, the upper surface of the horizontal channel portion 133H, and the inner surface of the second word line 150B, and have a U-shaped vertical cross-section on a Y-Z plane as seen in FIG. 2A. The gap-fill insulating layer 164 may be provided on the barrier insulating layer 162 within the inside of the U-shaped vertical cross-section of the barrier insulating layer 162 and in some embodiments may be in and may fill a gap between the first word line 150A and the second word line 150B.

Within one channel trench 115t, the first word line 150A and the second word line 150B are separated from each other by the barrier insulating layer 162 and the gap-fill insulating layer 164, but portions of the channel structure 133 may not be separated from each other by the barrier insulating layer 162 and the gap-fill insulating layer 164. The barrier insulating layer 162 may be in contact with the channel structure 133 but may not be in contact with the interfacial conductive pattern 131. The lower surface of the barrier insulating layer 162 may be in contact with the upper surface of the horizontal channel portion 133H.

Each of the barrier insulating layer 162 and the gap-fill insulating layer 164 may include at least one of silicon oxide, silicon oxynitride, or silicon nitride, or a combination of two or more thereof, but the present disclosure is not limited thereto. For example, the barrier insulating layer 162 may include silicon nitride and the gap-fill insulating layer 164 may include silicon oxide.

An insulating capping pattern 166 may be arranged on the word line 150 and the gap-fill insulating layer 164. The insulating capping pattern 166 may cover, for example, the upper surface of the word line 150, the upper surface of the barrier insulating layer 162, and the upper surface of the gap-fill insulating layer 164. The insulating capping pattern 166 may include silicon nitride but the present disclosure is not limited thereto. In some embodiments, the gate dielectric layer 140 may extend along a side surface of the word line 150 and a side surface of the insulating capping pattern 166 and cover the side surface of the word line 150 and the side surface of the insulating capping pattern 166. In some embodiments, the upper surface of the gate dielectric layer 140 and the upper surface of the insulating capping pattern 166 may be at the same vertical level and may be coplanar with each other.

A plurality of conductive contact patterns 173 may be arranged above the plurality of channel structures 133. Each of the plurality of conductive contact patterns 173 may be connected to one channel structure 133 selected from among the plurality of channel structures 133. For example, the plurality of conductive contact patterns 173 may be spaced apart from each other in the first horizontal direction (X direction) and the second horizontal direction (Y direction) and may be arranged in a matrix form in an X-Y plane. Each of the plurality of conductive contact patterns 173 may electrically connect the channel structure 133 to a capacitor structure 190 corresponding thereto. The conductive contact pattern 173 may include at least one of conductive materials, for example, a metal, a conductive metal nitride, a conductive metal carbonitride, a conductive metal carbide, a metal silicide, a doped semiconductor material, and/or a conductive metal oxynitride. The conductive contact pattern 173 may be in contact with a lower electrode 192 of the capacitor structure 190 and may also be referred to as a landing pad.

The plurality of conductive contact patterns 173 may be insulated from each other by an insulating structure 175. The insulating structure 175 may be arranged on the isolation insulating layer 115 and the insulating capping pattern 166 and may provide a space having therein the plurality of conductive contact patterns 173 and a plurality of interfacial oxide semiconductor patterns 171 to be described below. The insulating structure 175 may be formed of a nitride. Although FIG. 2A illustrates that the upper surface of the insulating structure 175 and the upper surface of the plurality of conductive contact patterns 173 are at a same vertical level, the inventive concepts of the present disclosure are not limited thereto. For example, the upper surface of the insulating structure 175 may be at a higher level than the upper surface of the plurality of conductive contact patterns 173. Although FIGS. 2A and 2B illustrate that the lower surface of the insulating structure 175 is at the same vertical level as the upper surface of the isolation insulating layer 115 and the upper surface of the insulating capping pattern 166, the inventive concepts of the present disclosure are not limited thereto. For example, the insulating structure 175 may extend into or through the isolation insulating layer 115 and/or into the insulating capping pattern 166 such that the lower surface of the insulating structure 175 is at a vertical level lower than the vertical level of the upper surface of the isolation insulating layer 115 and/or the vertical level of the upper surface of the insulating capping pattern 166.

In some embodiments, two adjacent conductive contact patterns 173 may be connected to one channel structure 133. For example, the upper surface of one vertical channel portion 133V of the channel structure 133 adjacent to the first word line 150A may be connected to one conductive contact pattern 173, and the upper surface of another vertical channel portion 133V of the channel structure 133 adjacent to the second word line 150B may be connected to another conductive contact pattern 173.

The plurality of interfacial oxide semiconductor patterns 171 may be provided between the plurality of conductive contact patterns 173 and the plurality of channel structures 133. Each of the plurality of conductive contact patterns 173 may be spaced apart from the corresponding channel structure 133 with one interfacial oxide semiconductor pattern 171 therebetween. The plurality of interfacial oxide semiconductor patterns 171 may be spaced apart from each other in the first horizontal direction (X direction) and the second horizontal direction (Y direction) and may be arranged in a matrix form in an X-Y plane. The plurality of interfacial oxide semiconductor patterns 171 may be insulated from each other by the insulating structure 175. Each interfacial oxide semiconductor pattern 171 may be in contact with the upper surface of the isolation insulating layer 115 and the upper surface of the insulating capping pattern 166 and may be in a space between the isolation insulating layer 115 and the gate dielectric layer 140.

The interfacial oxide semiconductor pattern 171 may include IGZO (InGaZnO), Sn-IGZO, ITO (InSnO), IWO (InWO), IZO (InZnO), IGO (InGaO), ITGO (InSnGaO), ZTO (ZnSnO), ZnO, YZO, IGSO (InGaSiO), InO, SnO, TiO, ZnON, MgZnO, ZrInZnO, HflnZnO, SnInZnO, SiInZnO, GaZnSnO, or ZrZnSnO, or a combination of two or more thereof. For example, the interfacial oxide semiconductor pattern 171 may be formed of IGZO.

In some embodiments, in a case in which the channel structure 133 includes the first oxide semiconductor material having the first composition, the interfacial oxide semiconductor pattern 171 may include a second oxide semiconductor material having a second composition that is different from the first composition of the channel structure 133.

In some embodiments, the second oxide semiconductor material of the interfacial oxide semiconductor pattern 171 may be an indium-rich metal oxide semiconductor material having high indium content. The first oxide semiconductor material of the channel structure 133 and the second oxide semiconductor material of the interfacial oxide semiconductor pattern 171 are each a metal oxide semiconductor material containing indium, and the indium content of the second oxide semiconductor material of the interfacial oxide semiconductor pattern 171 may be greater than the indium content of the first oxide semiconductor material of the channel structure 133. For example, the indium mole fraction of the second oxide semiconductor material of the interfacial oxide semiconductor pattern 171 may be greater than the indium mole fraction of the first oxide semiconductor material of the channel structure 133.

Each interfacial oxide semiconductor pattern 171 may include a lower pattern 171L in contact with the channel structure 133, and an upper pattern 171U in contact with the conductive contact pattern 173. The lower pattern 171L may be in a space formed between the isolation insulating layer 115 and the gate dielectric layer 140, and the lower pattern 171L may extend along a sidewall of the isolation insulating layer 115. The lower pattern 171L may extend in the vertical direction (Z direction) from the upper surface of the channel structure 133 (i.e., the upper surface of the vertical channel portion 133V) to the vertical level of the upper surface of the isolation insulating layer 115. The lower pattern 171L may include a side surface in contact with the isolation insulating layer 115, a side surface in contact with the gate dielectric layer 140, and a bottom surface in contact with the upper surface of the vertical channel portion 133V of the channel structure 133. The upper pattern 171U may be arranged on the lower pattern 171L, the isolation insulating layer 115, and the insulating capping pattern 166 and may be integral with the lower pattern 171L. The upper pattern 171U may be in contact with the upper surface of the isolation insulating layer 115, the upper surface of the gate dielectric layer 140, and the upper surface of the insulating capping pattern 166, and the upper surface of the upper pattern 171U may be in contact with the conductive contact pattern 173.

As illustrated in the cross-sectional view of FIG. 2A, the width of each upper pattern 171U in the second horizontal direction (direction Y) may be greater than the width of each lower pattern 171L in the second horizontal direction (direction Y). In the cross-sectional view, the entire upper surface of each upper pattern 171U may be covered by the corresponding conductive contact pattern 173. In a cross-sectional view, the width of each upper pattern 171U in the second horizontal direction (direction Y) may be substantially equal to the width of the corresponding conductive contact pattern 173 in the second horizontal direction (direction Y), and the side surfaces of each upper pattern 171U may be aligned with the side surfaces of the corresponding conductive contact pattern 173 in the vertical direction (Z direction).

The contact area between the interfacial oxide semiconductor pattern 171 and the conductive contact pattern 173 (that is, the contact area between the upper surface of the upper pattern 171U and the lower surface of the conductive contact pattern 173) may be greater than the contact area between the interfacial oxide semiconductor pattern 171 and the channel structure 133 (that is, the contact area between the lower surface of the lower pattern 171L and the upper surface of the vertical channel portion 133V).

The interfacial oxide semiconductor pattern 171 may expand the contact area between the conductive contact pattern 173 and an oxide semiconductor material layer. That is, the contact area between the conductive contact pattern 173 and the interfacial oxide semiconductor pattern 171 formed by direct contact between the conductive contact pattern 173 and the interfacial oxide semiconductor pattern 171 may be greater than the contact area between the conductive contact pattern 173 and the channel structure 133 formed by direct contact between the conductive contact pattern 173 and the channel structure 133. Because the interfacial oxide semiconductor pattern 171 has a relatively large contact area with the conductive contact pattern 173, the total contact resistance formed between the channel structure 133 and the conductive contact pattern 173 may be reduced and accordingly, the reliability of a transistor including the channel structure 133 and the reliability of the semiconductor memory device 1 may be improved.

Furthermore, the interfacial oxide semiconductor pattern 171 may contain an oxide semiconductor material having higher conductivity than that of the oxide semiconductor material included in the channel structure 133, between the conductive contact pattern 173 and the channel structure 133, and accordingly a Schottky barrier may be lower than when the conductive contact pattern 173 is in direct contact with the channel structure 133. Accordingly, the total contact resistance formed between the channel structure 133 and the conductive contact pattern 173 may be reduced, and thus, the reliability of a transistor including the channel structure 133 and the reliability of the semiconductor memory device 1 may be improved.

A support insulating layer 180 may be arranged on the plurality of conductive contact patterns 173 and the insulating structure 175. The support insulating layer 180 may cover the plurality of conductive contact patterns 173 and the insulating structure 175 and may have a plurality of holes positioned to overlap the plurality of conductive contact patterns 173. The support insulating layer 180 may be formed of, for example, a silicon nitride film or silicon boron nitride (SiBN).

A plurality of capacitor structures 190 may be arranged on the plurality of conductive contact patterns 173. Each of the plurality of capacitor structures 190 may be connected to the upper surface of the corresponding conductive contact pattern 173 among the plurality of conductive contact patterns 173. The capacitor structure 190 may be controlled by the conductive line 120 and the word line 150 to store data.

The plurality of capacitor structures 190 may include a plurality of lower electrodes 192, a capacitor dielectric film 194, and an upper electrode 196. Each of the plurality of capacitor structures 190 may store a charge in the capacitor dielectric film 194 by using the potential difference generated between the lower electrode 192 and the upper electrode 196.

The plurality of lower electrodes 192 may be connected to the plurality of conductive contact patterns 173. For example, the plurality of lower electrodes 192 may be connected to the upper surfaces of the plurality of conductive contact patterns 173 exposed by the plurality of holes of the support insulating layer 180. FIG. 2A illustrates that the lower electrode 192 has a pillar shape extending in the vertical direction (Z direction) from the upper surface of the conductive contact pattern 173, but this is only one example. In some embodiments, the lower electrode 192 may have a cylindrical shape extending in the vertical direction (Z direction) from the upper surface of the conductive contact pattern 173. In embodiments, the plurality of lower electrodes 192 may be arranged in a matrix form on an X-Y plane. In some embodiments, the plurality of lower electrodes 192 may be arranged in a honeycomb shape on an X-Y plane. The lower electrode 192 may include silicon doped with impurities, a metal such as tungsten or copper, and/or a conductive metal compound such as titanium nitride.

The capacitor dielectric film 194 may be formed on the plurality of lower electrodes 192. In embodiments, the capacitor dielectric film 194 may extend along and conform to the side surfaces and upper surfaces of the plurality of lower electrodes 192, and the upper surface of the support insulating layer 180. The capacitor dielectric film 194 may be formed of, for example, TaO, TaAlO, TaON, AlO, AlSiO, HfO, HfSiO, ZrO, ZrSiO, TiO, TiAlO, barium strontium titanate BST ((Ba,Sr)TiO), strontium titanate STO (SrTiO), barium titanate BTO (BaTiO)), lead zirconium titanate PZT (Pb(Zr, Ti)O), (Pb, La)(Zr, Ti)O, Ba(Zr, Ti)O, or Sr(Zr, Ti)O, or a combination of two or more thereof.

The upper electrode 196 may be formed on the capacitor dielectric film 194. The upper electrode 196 may include a metal material. For example, the upper electrode 196 may include W, Ru, RuO, Pt, PtO, Ir, IrO, strontium ruthenate SRO (SrRuO), barium strontium ruthenate BSRO ((Ba,Sr)RuO), calcium ruthenate CRO (CaRuO), BaRuO, or La(Sr, Co)O, or a combination of two or more thereof. In some embodiments, the upper electrode 196 may further include at least one of a doped semiconductor material layer and an interfacial layer in addition to the metal material and thus have may have a stack structure thereof. The doped semiconductor material layer may include, for example, at least one of doped polysilicon and doped polycrystalline silicon germanium (SiGe). The interfacial layer may include, for example, at least one of a metal oxide, a metal nitride, a metal carbide, and a metal silicide.

In the semiconductor memory device 1 according to the inventive concepts, with the interfacial conductive pattern 131 between the channel structure 133 containing the oxide semiconductor material and the conductive line 120, the total contact resistance between the channel structure 133 and the bit line may be reduced. In addition, with the interfacial oxide semiconductor pattern 171 between the channel structure 133 containing the oxide semiconductor material and the conductive contact pattern 173, the total contact resistance between the channel structure 133 and the conductive contact pattern 173 may be reduced. Thus, the performance and reliability of the semiconductor memory device 1 may be improved.

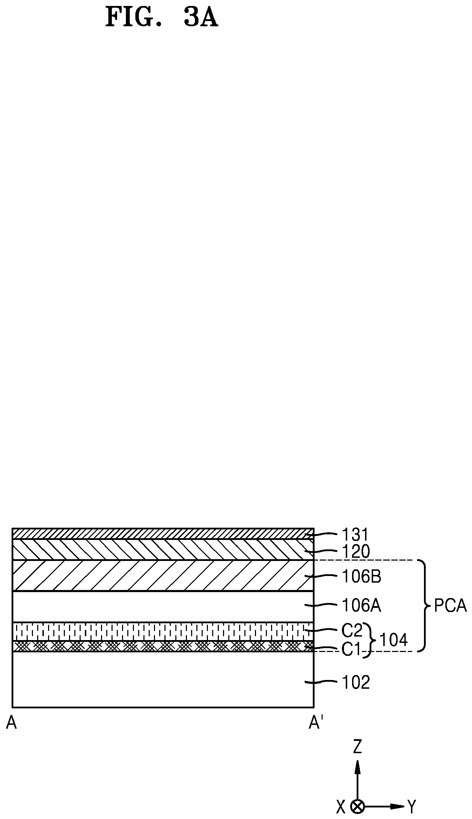

FIGS. 3A to 17B are cross-sectional views for describing a method of fabricating a semiconductor memory device, according to some embodiments. In greater detail, FIGS. 3A to 17B are cross-sectional views for describing a method of fabricating the semiconductor memory device 1 illustrated in FIGS. 1 to 2B, and FIGS. 3A, 4A, 5A, 6A, 7A, 8A, 9A, 10A, 11A, 12A, 13A, 14A, 15A, 16A, and 17A are cross-sectional views taken along line A-A' of FIG. 1, and FIGS. 3B, 4B, 5B, 6B, 7B, 8B, 9B, 10B, 11B, 12B, 13B, 14B, 15B, 16B, and 17B are cross-sectional views taken along line B-B' of FIG. 1.

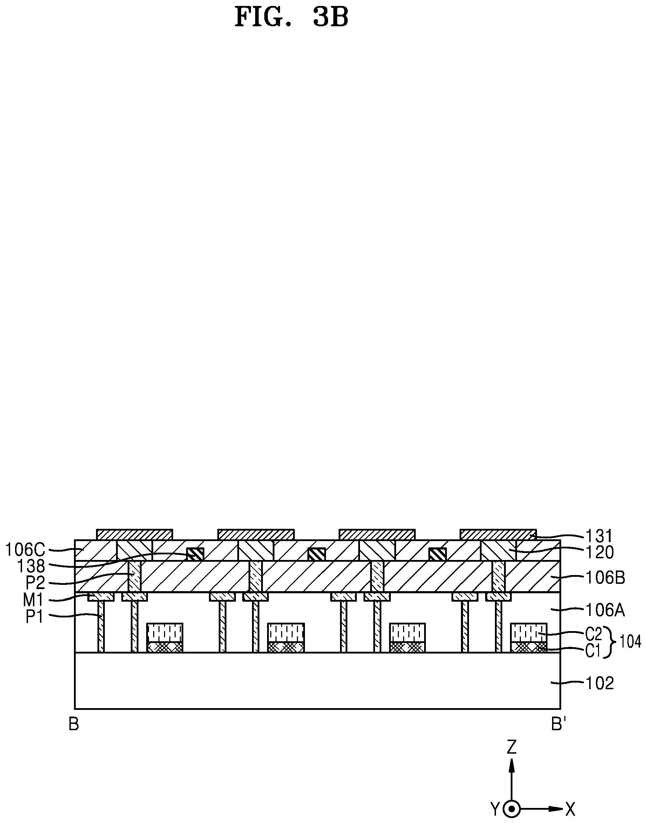

Referring to FIGS. 3A and 3B, the peripheral circuit structure PCA may be formed on the substrate 102 by forming, on the substrate 102, a plurality of peripheral circuits including a plurality of core circuits 104, a plurality of conductive plugs P1 and P2, and a wiring layer M1. Thereafter, a plurality of shielding structures 138 covered by the interlayer insulating film 106C provided on the peripheral circuit structure PCA, and a plurality of conductive lines 120 that penetrate or extend through the interlayer insulating film 106C may be formed. Next, a conductive material layer may be formed to cover the plurality of conductive lines 120 and the interlayer insulating film 106C, and the plurality of interfacial conductive patterns 131 may be formed by patterning the conductive material layer.

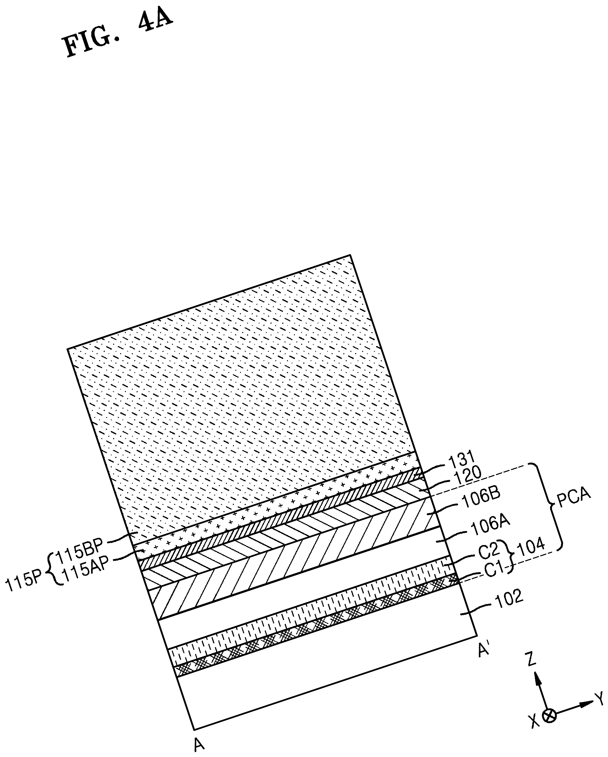

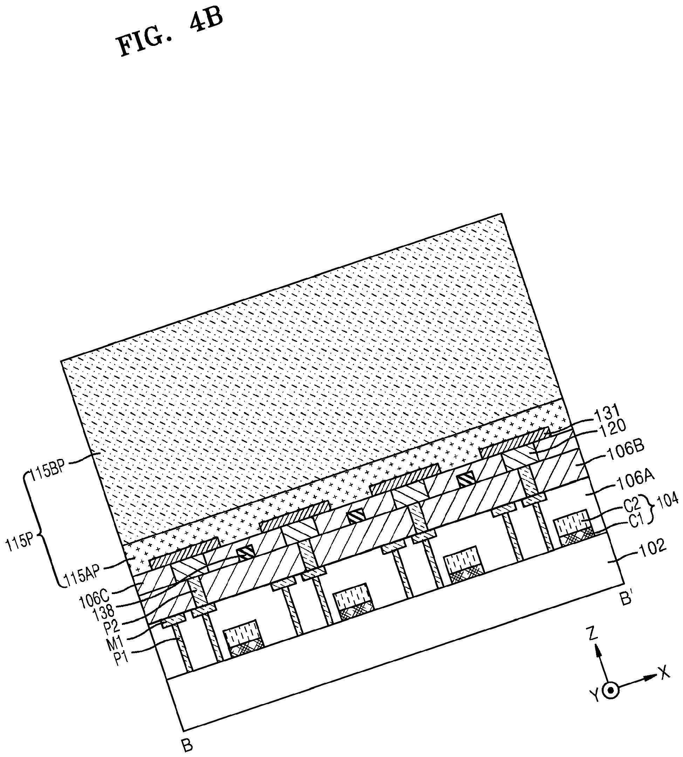

Referring to FIGS. 4A and 4B, after forming the plurality of interfacial conductive patterns 131, a preliminary isolation insulating layer 115P may be formed to cover the plurality of interfacial conductive patterns 131 and the interlayer insulating film 106C. The preliminary isolation insulating layer 115P may be formed to have a stack structure of a preliminary lower isolation insulating layer 115 AP and a preliminary upper isolation insulating layer 115BP. In some embodiments, the preliminary lower isolation insulating layer 115AP may be formed of a nitride and the preliminary upper isolation insulating layer 115BP may be formed of an oxide.

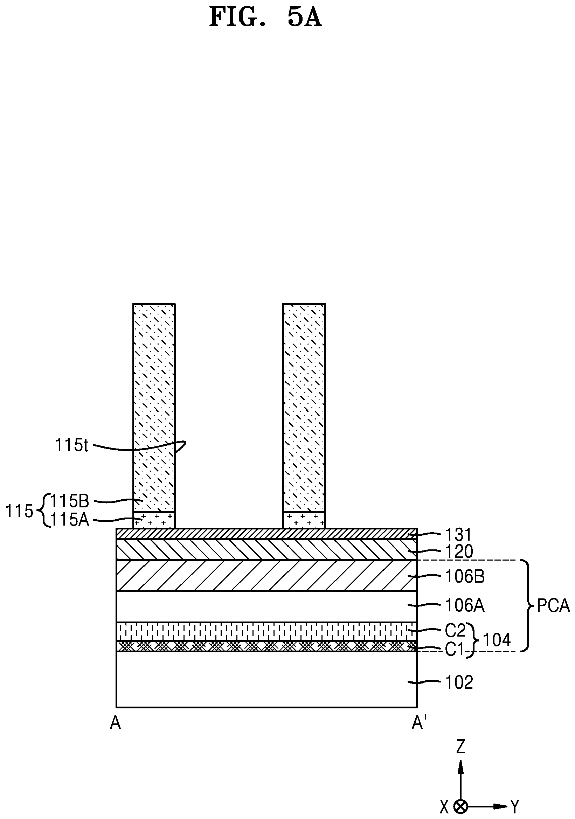

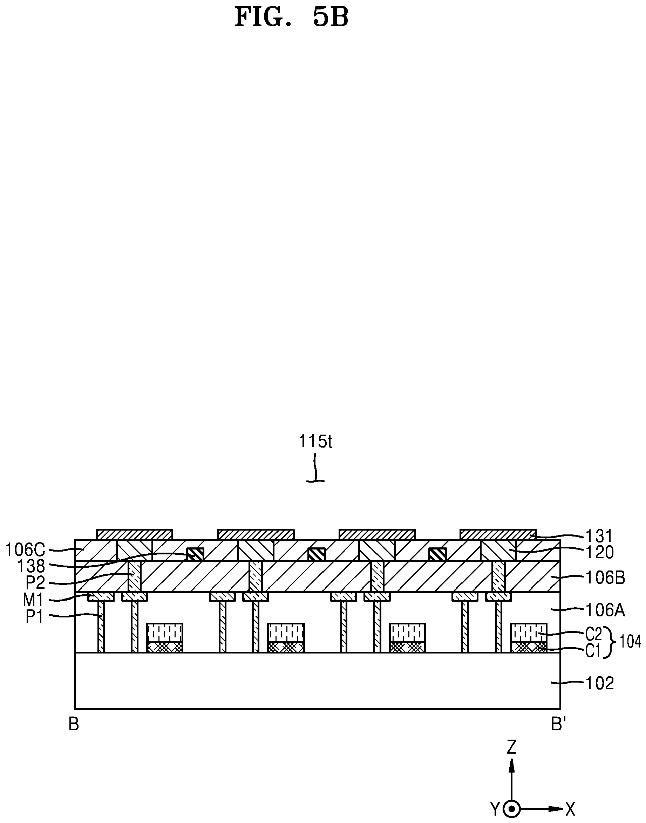

Referring to FIGS. 4A, 4B, 5A, and 5B, an isolation insulating layer 115 including a plurality of channel trenches 115t may be formed by patterning the preliminary isolation insulating layer 115P. The isolation insulating layer 115 may have a stack structure of the lower isolation insulating layer 115A and the upper isolation insulating layer 115B.

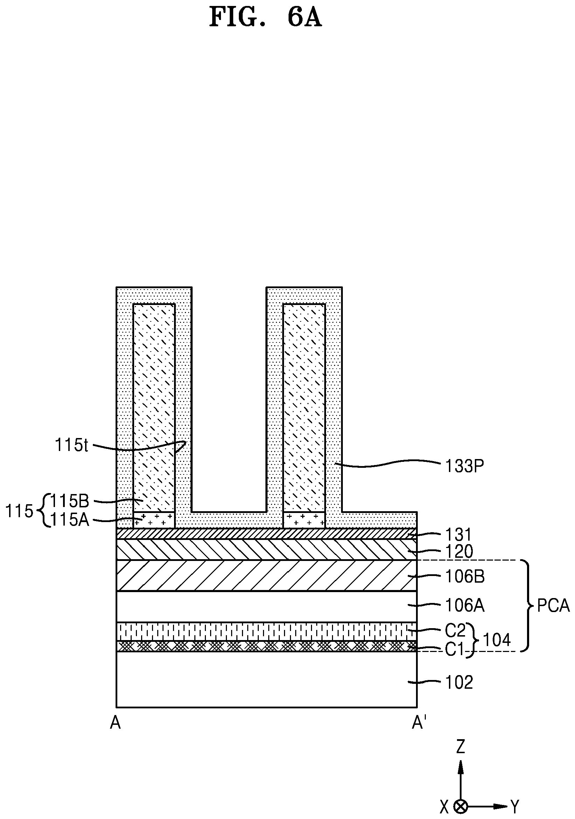

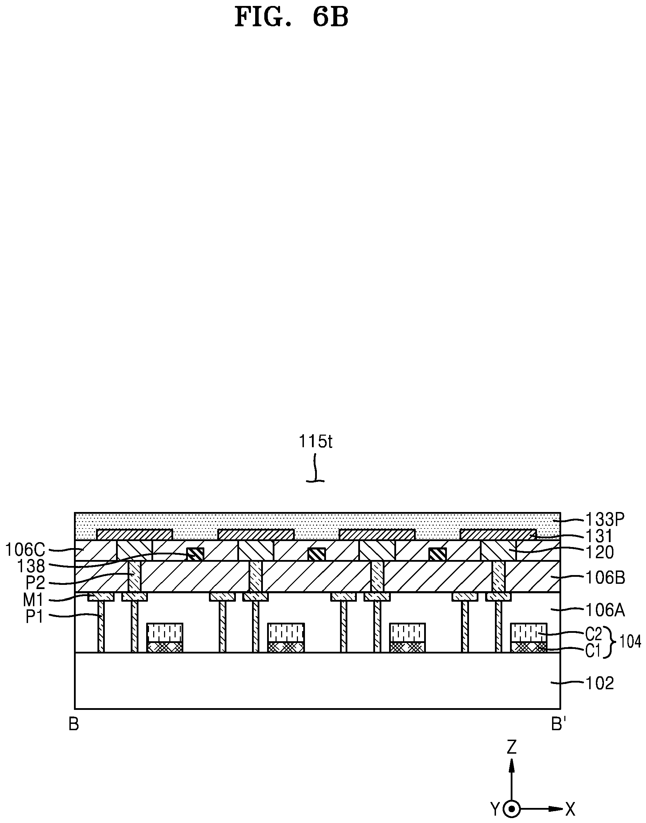

Referring to FIGS. 6A and 6B, a preliminary channel layer 133P may be formed to cover the surface of the result of FIGS. 5A and 5B. The preliminary channel layer 133P may cover the upper and side surfaces of the isolation insulating layer 115, the interfacial conductive pattern 131 exposed through the channel trench 115t, and the interlayer insulating film 106C.

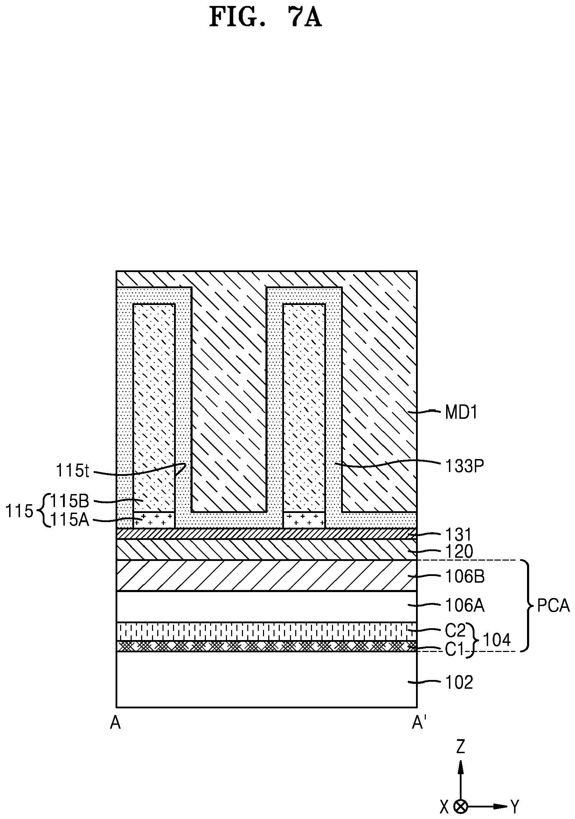

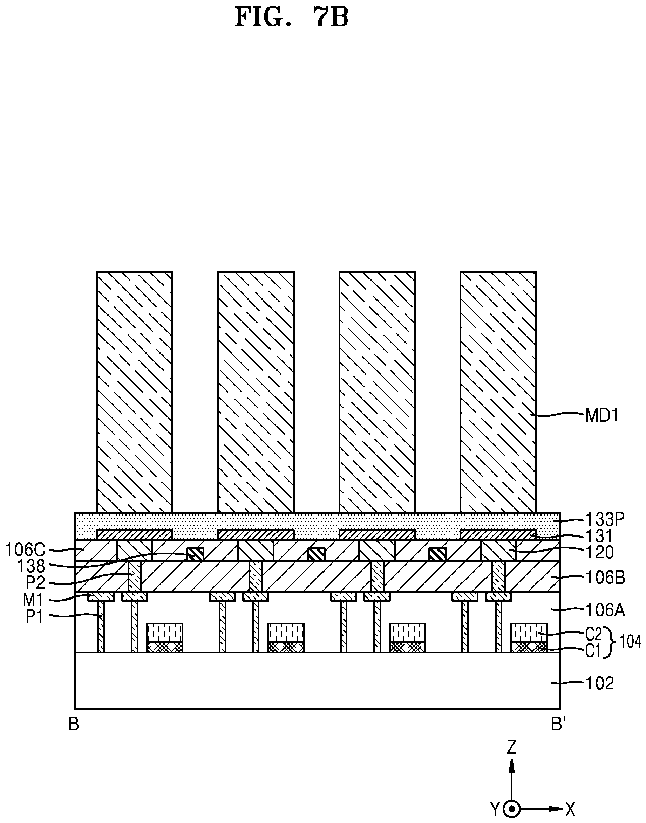

Referring to FIGS. 7A and 7B, a plurality of first mold layers MD1 may be formed on the preliminary channel layer 133P. The plurality of first mold layers MD1 may extend in the second horizontal direction (Y direction) within the channel trench 115t. For example, forming a preliminary mold layer that covers the preliminary channel layer 133P and patterning the preliminary mold layer may be sequentially performed to form the plurality of first mold layers MD1.

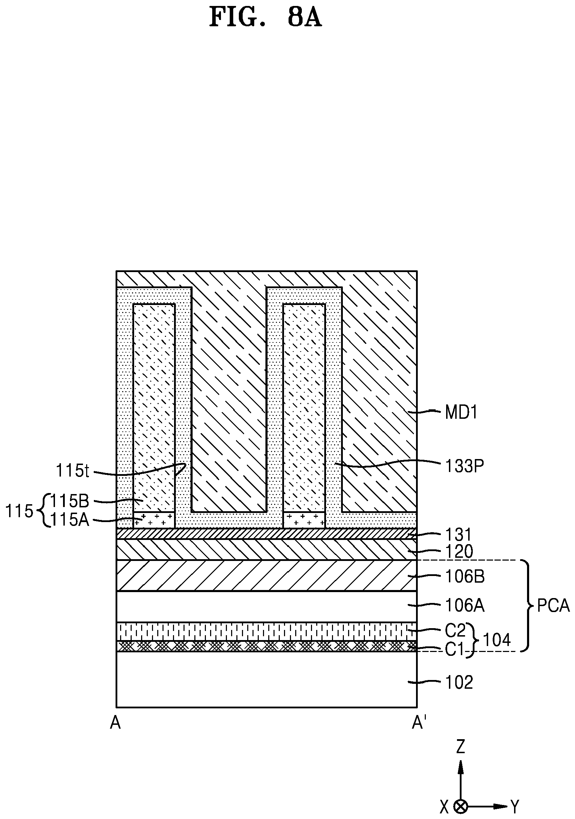

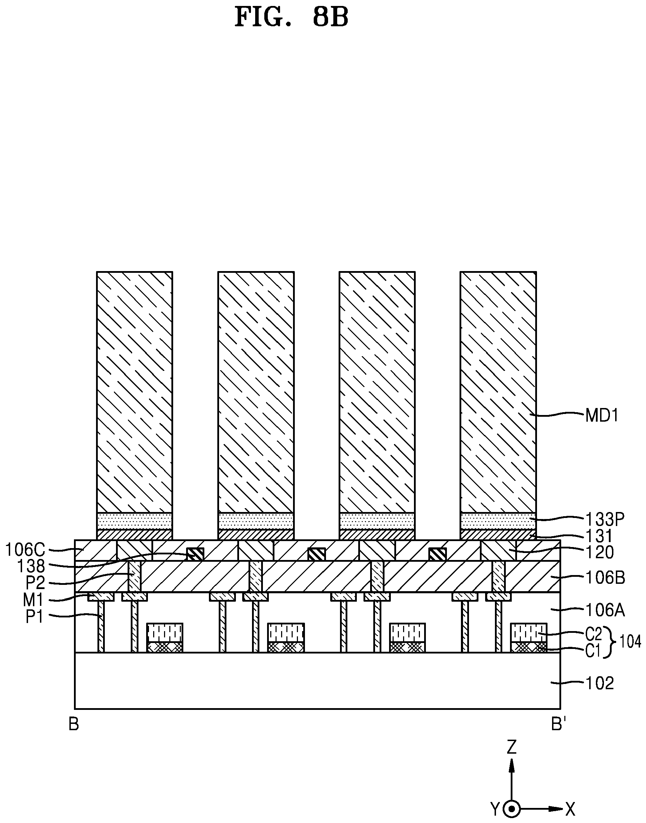

Referring to FIGS. 7A, 7B, 8A, and 8B, a portion of the preliminary channel layer 133P may be removed by using the plurality of first mold layers MD1 as an etch mask. As the portion of the preliminary channel layer 133P is removed, portions of the upper surface of the interlayer insulating film 106C may be exposed.

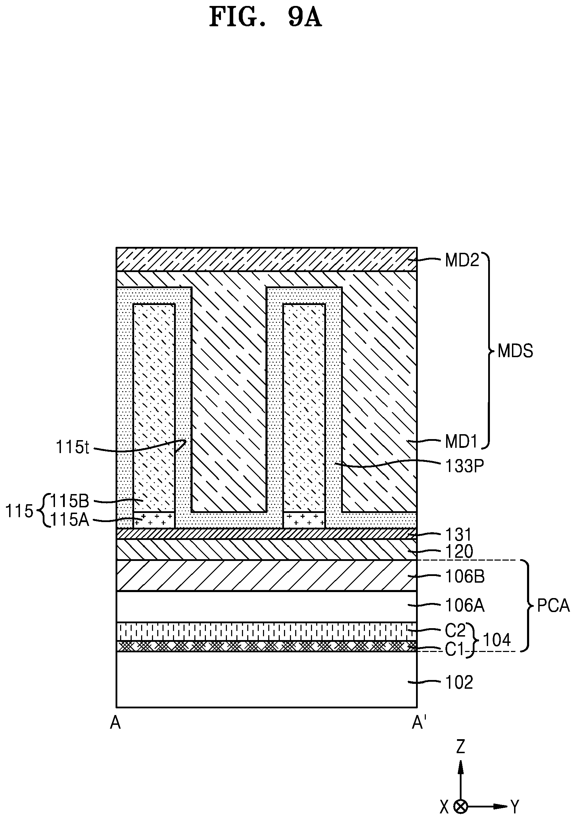

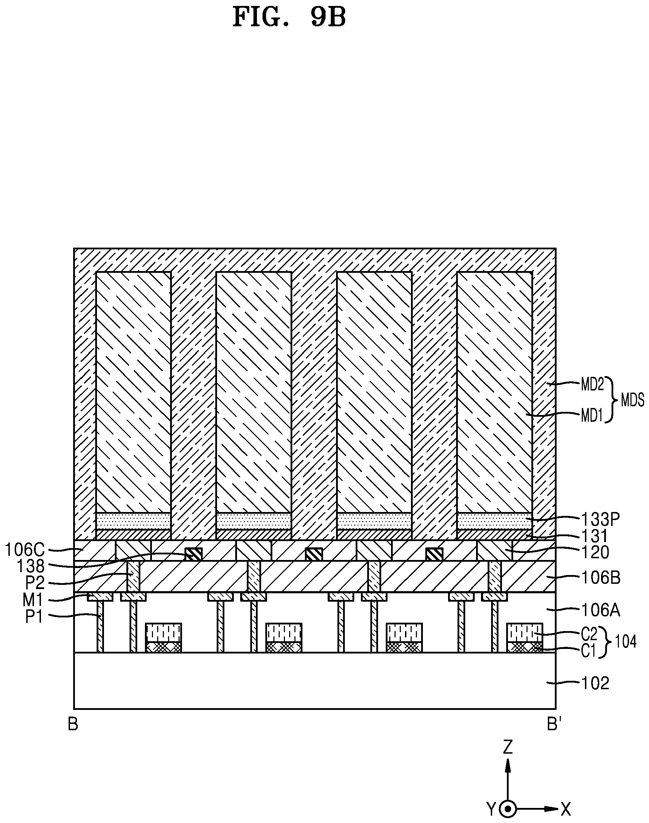

Referring to FIGS. 9A and 9B, a second mold layer MD2 may be formed in a space between the plurality of first mold layers MD1 and may cover the upper surfaces of the plurality of first mold layers MD1. A stack structure of the plurality of first mold layers MD1 and the second mold layer MD2 may be referred to as a mold structure MDS.

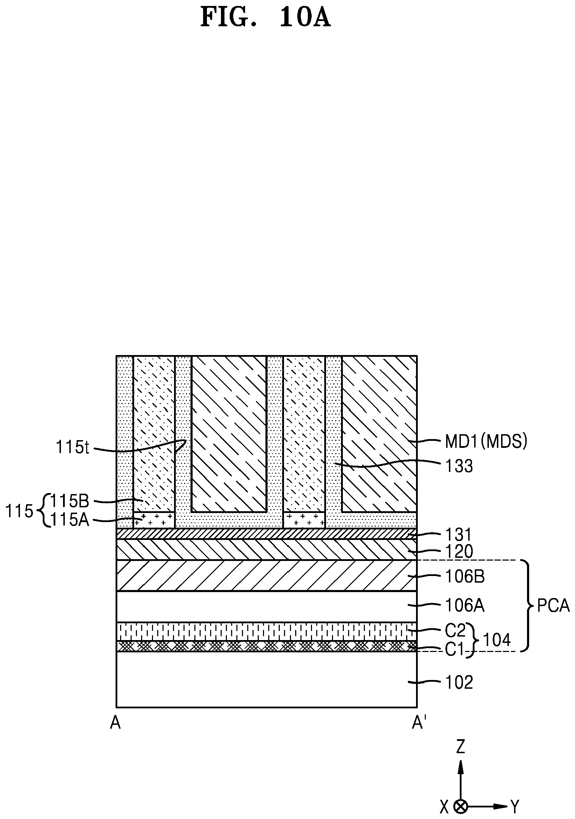

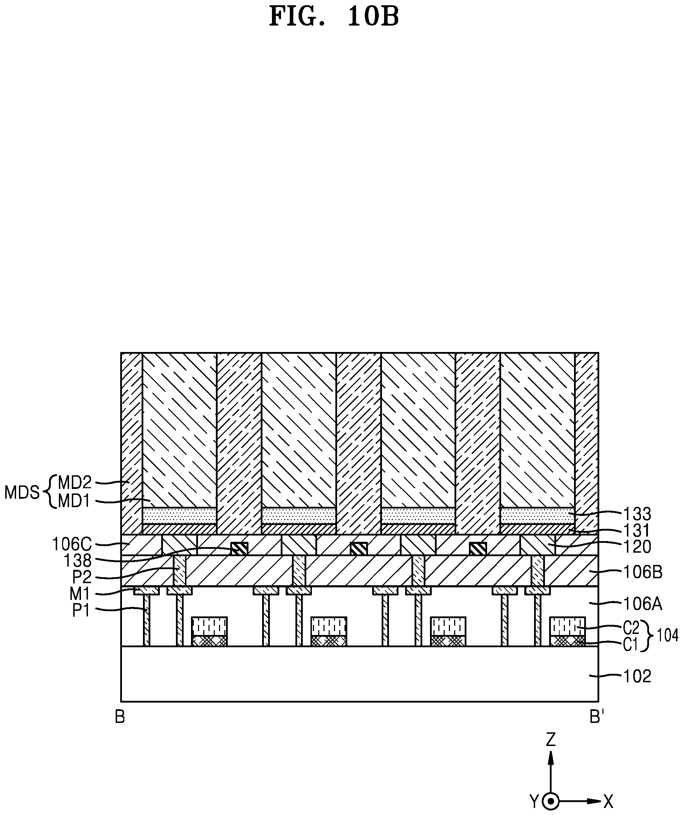

Referring to FIGS. 9A, 9B, 10A, and 10B, an upper portion of the mold structure MDS and a portion of the preliminary channel layer 133P covering the upper surfaces of a plurality of isolation insulating layers 115 may be removed. The upper portion of the mold structure MDS and the portion of the preliminary channel layer 133P may be removed through a polishing process. A portion of the preliminary channel layer 133P remaining after the polishing process on the preliminary channel layer 133P forms a plurality of channel structures 133.

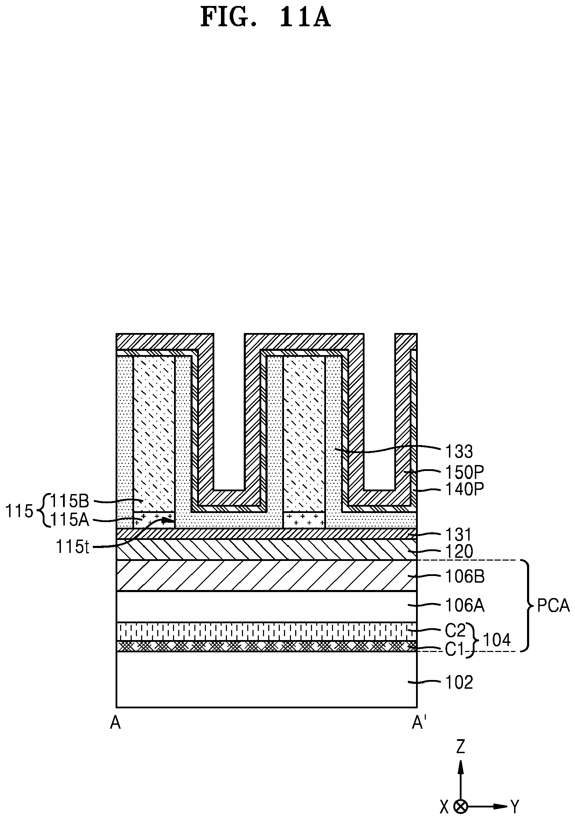

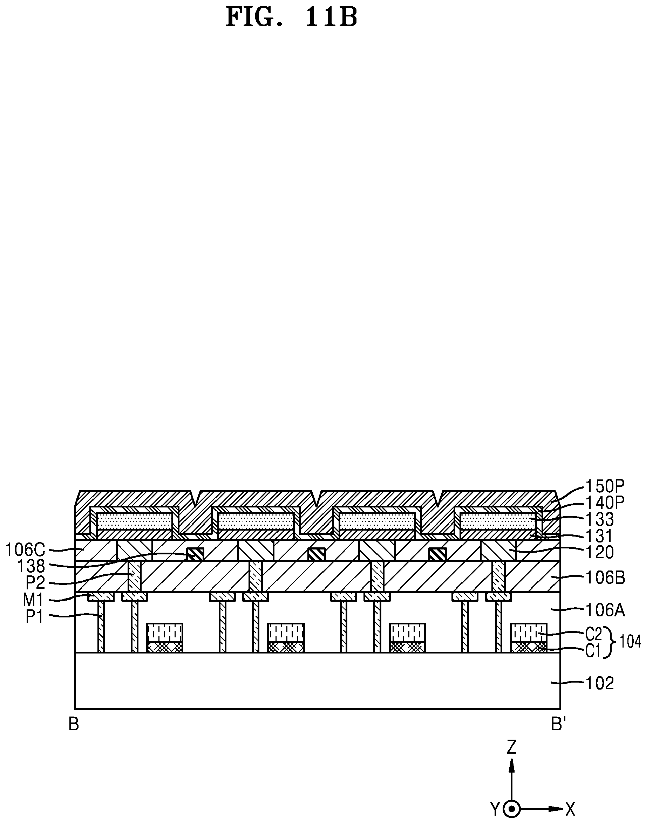

Referring to FIGS. 10A, 10B, 11A, and 11B, after removing the mold structure MDS, a preliminary gate dielectric layer 140P that covers and conforms to the upper surface of the isolation insulating layer 115 and the upper and side surfaces of each channel structure 133, and a preliminary word line material layer 150P are sequentially formed. The preliminary gate dielectric layer 140P and the preliminary word line material layer 150P may be formed in only a portion of the channel trench 115t.

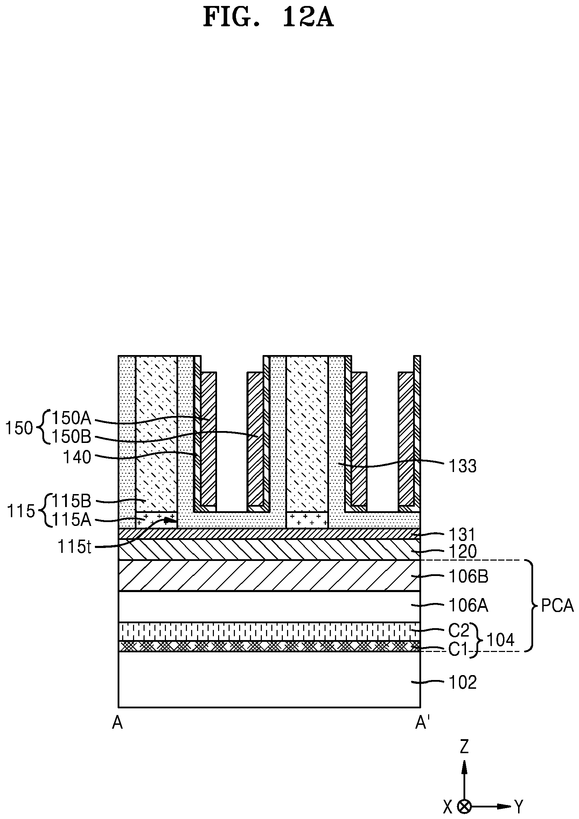

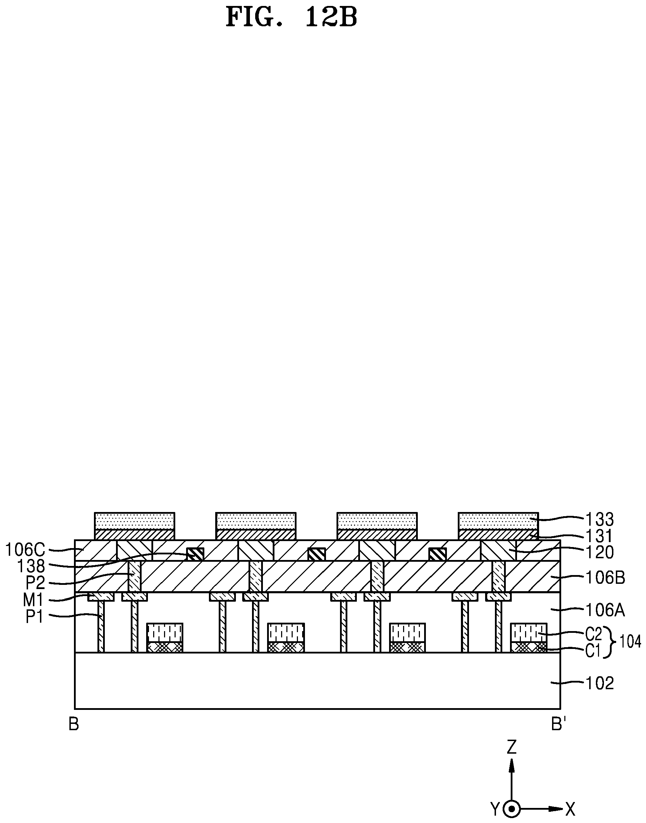

Referring to FIGS. 11A, 11B, 12A, and 12B, the gate dielectric layer 140 and the word line 150 may be formed by removing a portion of the preliminary gate dielectric layer 140P and a portion of the preliminary word line material layer 150P on the upper surface of the isolation insulating layer 115 and the upper surfaces of the plurality of channel structures 133, and then removing a portion of the preliminary word line material layer 150P covering the upper portion of the sidewall of the isolation insulating layer 115, and a portion of the preliminary word line material layer 150P in a lower portion of the channel trench 115t. For example, anisotropic etching may be performed on the preliminary word line material layer 150P to remove a portion of the preliminary word line material layer 150P covering an upper portion of the sidewall of the isolation insulating layer 115, and a portion of the preliminary word line material layer 150P in a lower portion of the channel trench 115t. In embodiments, the word line 150 may be formed to include the first word line 150A and the second word line 150B opposite to each other within one channel trench 115t.

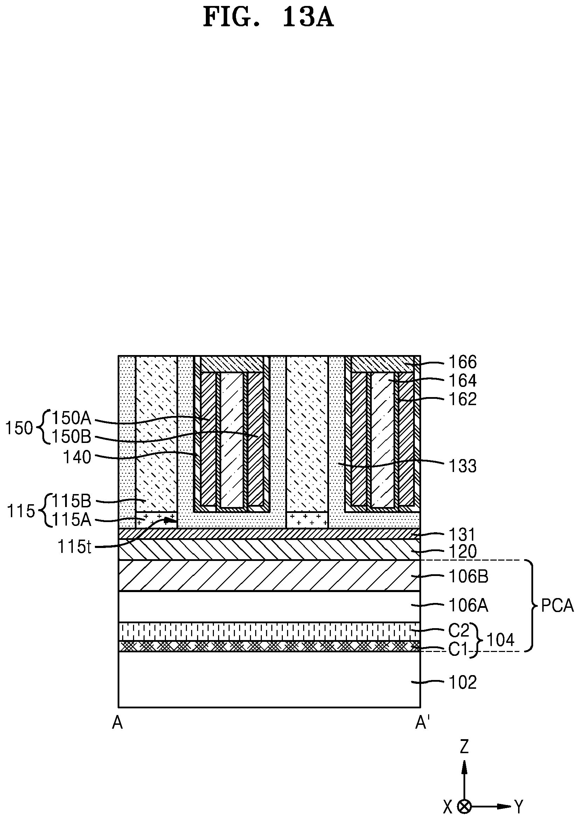

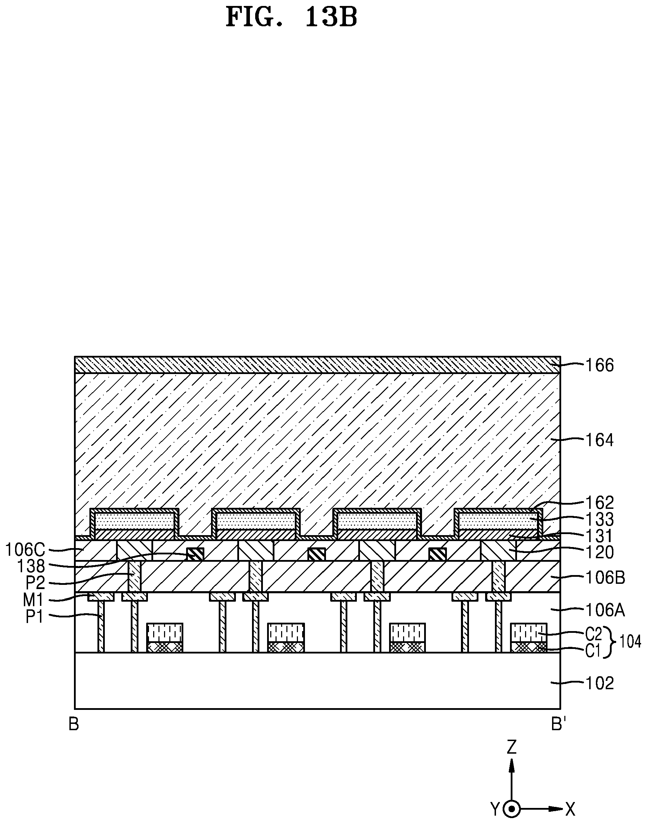

Referring to FIGS. 13A and 13B, the barrier insulating layer 162 extending on and conforming to the word line 150 and the channel structure 133 within the channel trench 115t, the gap-fill insulating layer 164 covering the barrier insulating layer 162 and in a space defined by the barrier insulating layer 162 within the channel trench 115t, and the insulating capping pattern 166 covering the upper surface of the word line 150, the upper surface of the barrier insulating layer 162, and the upper surface of the gap-fill insulating layer 164 are sequentially formed.

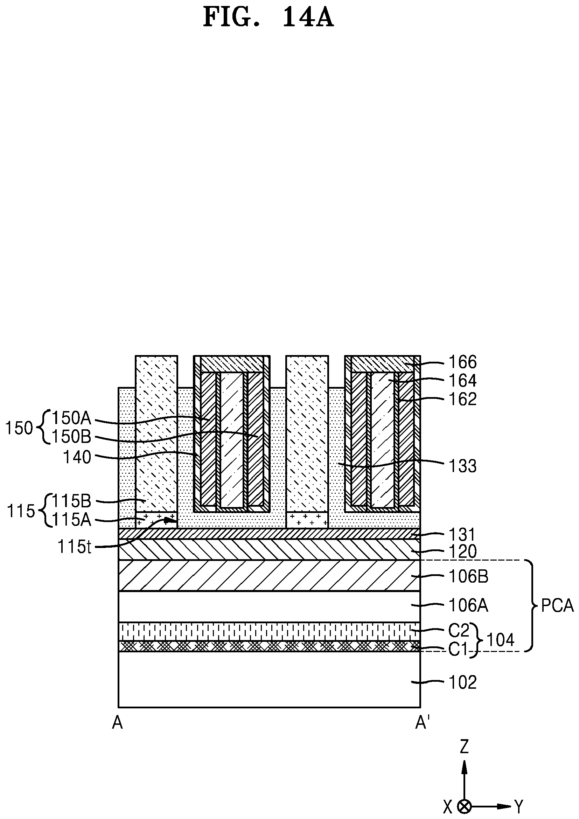

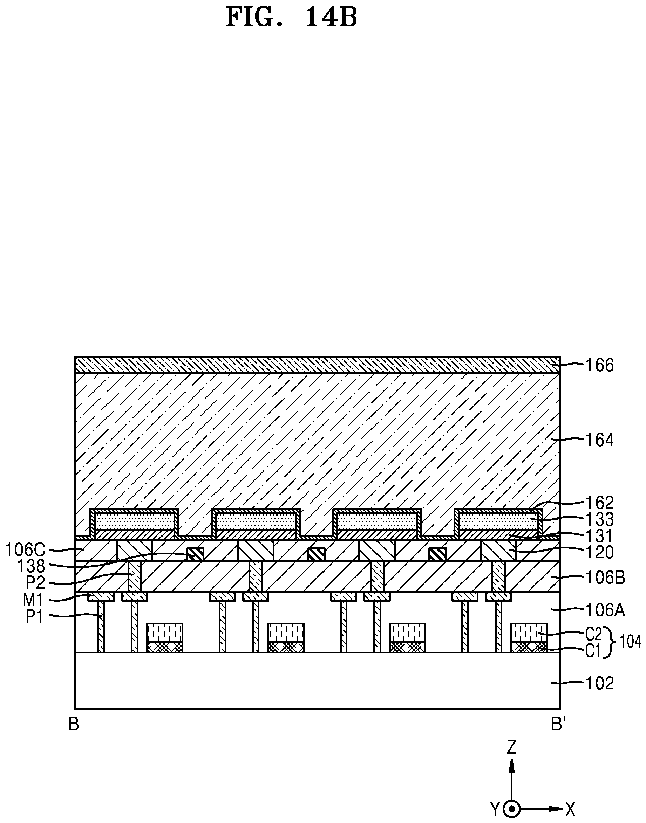

Referring to FIGS. 13A, 13B, 14A, and 14B, an upper portion of the channel structure 133 may be removed. As the upper portion of the channel structure 133 is removed, the top of the channel structure 133 may be at a vertical level lower than the vertical level of the top of the word line 150.

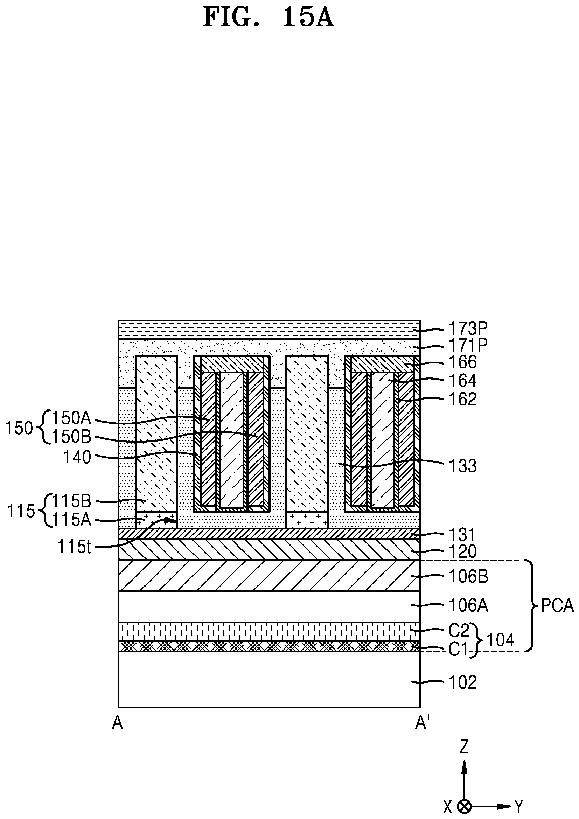

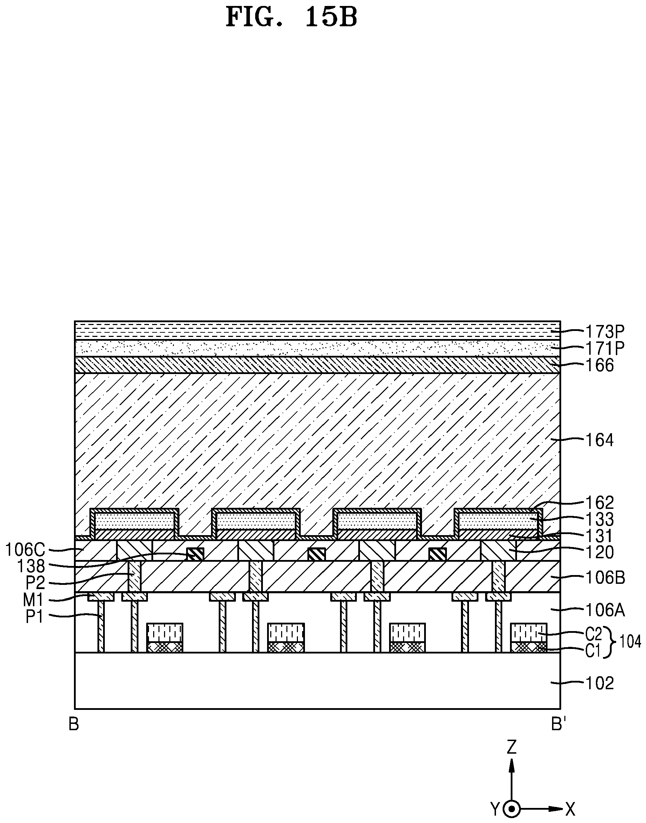

Referring to FIGS. 15A and 15B, an interfacial oxide semiconductor material layer 171P and a contact material layer 173P may be sequentially formed on the result of FIGS. 14A and 14B. The interfacial oxide semiconductor material layer 171P may be in a space defined between the sidewall of the isolation insulating layer 115 and the gate dielectric layer 140 and may be in contact with the upper surface of the channel structure 133. The interfacial oxide semiconductor material layer 171P may cover the upper surface of the isolation insulating layer 115 and the upper surface of the insulating capping pattern 166. The contact material layer 173P may cover the interfacial oxide semiconductor material layer 171P.

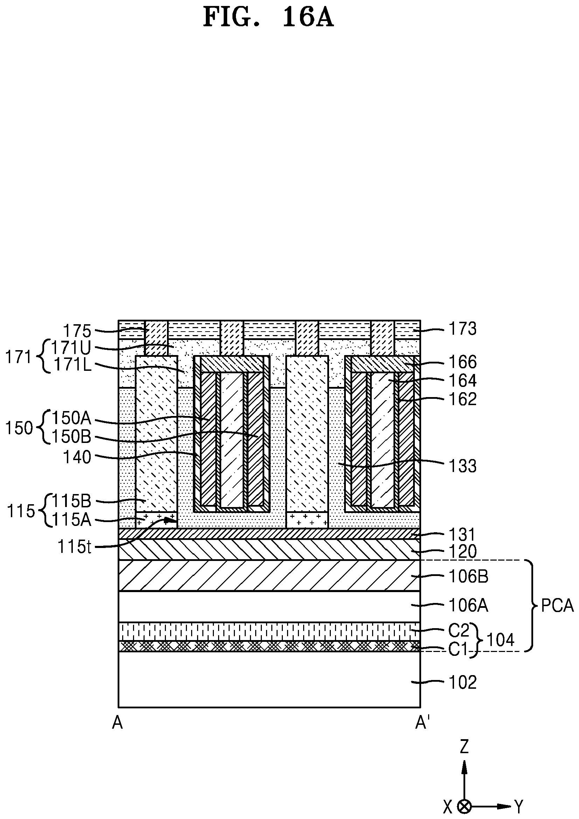

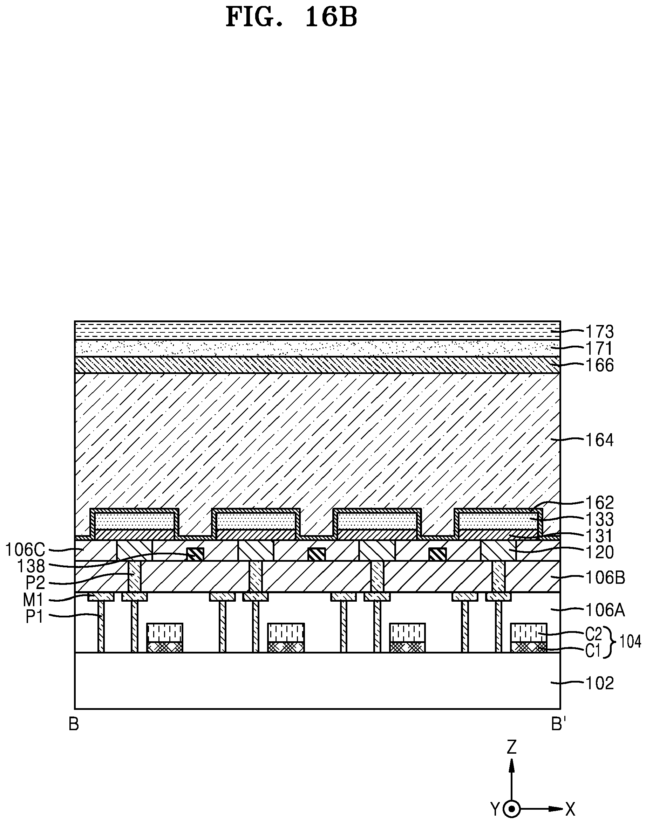

Referring to FIGS. 15A, 15B, 16A, and 16B, a portion of the contact material layer 173P and a portion of the interfacial oxide semiconductor material layer 171P may be removed. For example, a mask pattern may be formed on the contact material layer 173P, and a portion of the contact material layer 173P and a portion of the interfacial oxide semiconductor material layer 171P may be removed by using the mask pattern as an etch mask. A plurality of conductive contact patterns 173 may be formed by removing a portion of the contact material layer 173P, and a plurality of interfacial oxide semiconductor patterns 171 may be formed by removing a portion of the interfacial oxide semiconductor material layer 171P. The insulating structure 175 may be formed in a space formed by removing the portion of the contact material layer 173P and in a space formed by removing the portion of the interfacial oxide semiconductor material layer 171P.

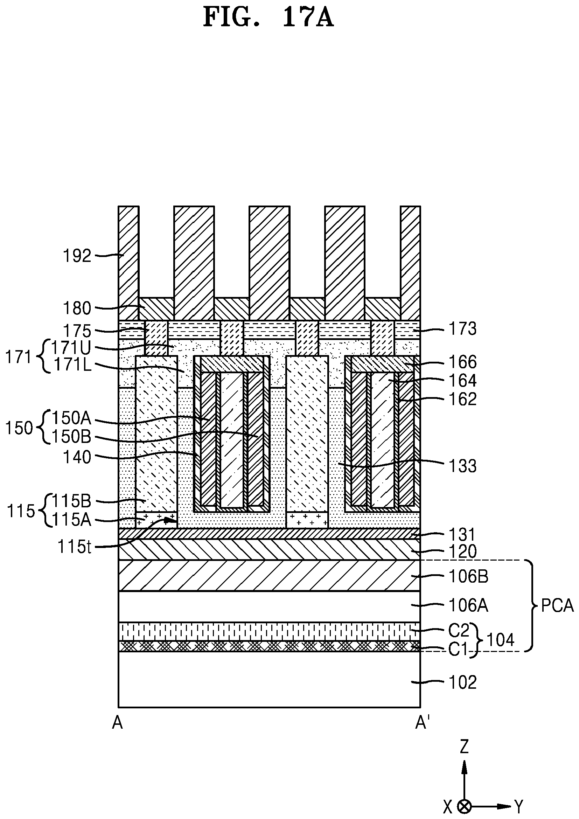

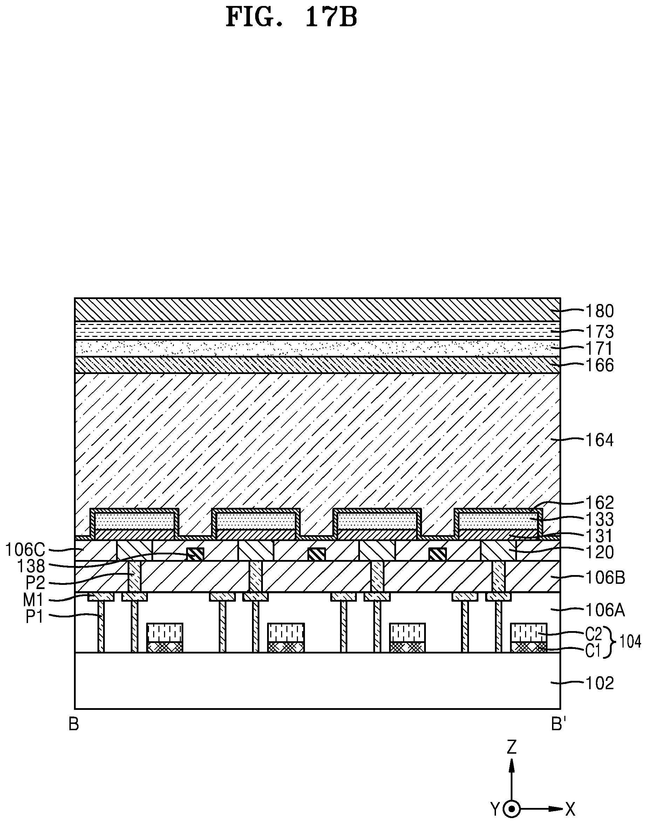

Referring to FIGS. 17A and 17B, the support insulating layer 180 may be formed on the plurality of conductive contact patterns 173 and the insulating structure 175. The support insulating layer 180 may have a plurality of holes through which the plurality of conductive contact patterns 173 are exposed. Thereafter, a plurality of lower electrodes 192 may be formed on the plurality of conductive contact patterns 173. The plurality of lower electrodes 192 may be formed to extend in the vertical direction (Z direction) from the upper surface of the conductive contact pattern 173 exposed through the plurality of holes of the support insulating layer 180.

Next, referring to FIGS. 2A and 2B, the semiconductor memory device 1 including a plurality of capacitor structures 190 may be formed by sequentially forming the capacitor dielectric film 194 and the upper electrode 196 on the plurality of lower electrodes 192.

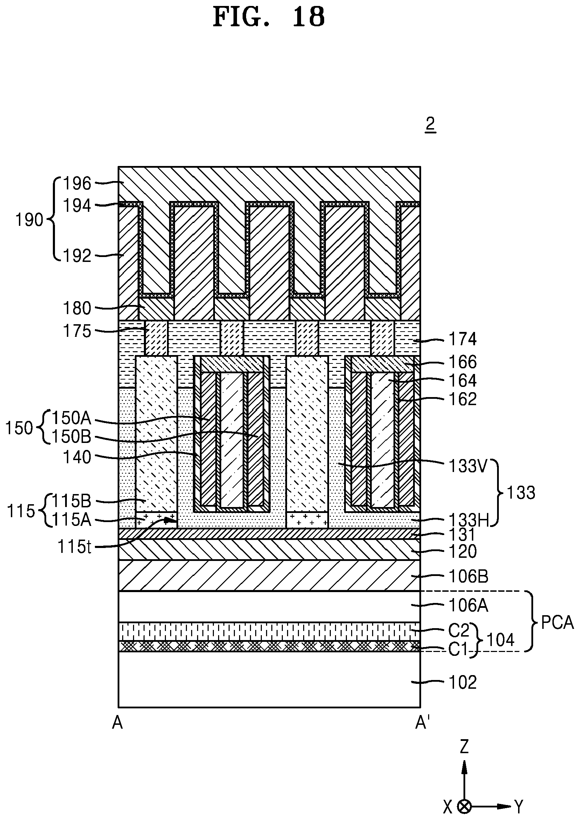

FIG. 18 is a cross-sectional view illustrating a semiconductor memory device 2 according to some embodiments. Hereinafter, the semiconductor memory device 2 illustrated in FIG. 18 is described, focusing on the difference from the semiconductor memory device 1 described above with reference to FIGS. 1 to 2B.

Referring to FIG. 18, in the semiconductor memory device 2, a plurality of interfacial oxide semiconductor patterns (171 of FIG. 2A) may be omitted and a plurality of conductive contact patterns 174 may be in direct contact with the corresponding channel structures 133, respectively. A lower portion of each conductive contact pattern 174 may be in a gap between the sidewall of the isolation insulating layer 115 and the gate dielectric layer 140 and may be in contact with the upper surface of the channel structure 133.

In the semiconductor memory device 2, each conductive line 120 and each interfacial conductive pattern 131 in contact with each other may constitute a bit line structure that may function as a bit line of the semiconductor memory device 2. Because the contact area between the channel structure 133 and the bit line may be expanded by the interfacial conductive pattern 131, the contact resistance between the channel structure 133 containing an oxide semiconductor material and the bit line may be reduced and ultimately, the reliability of the transistor including the channel structure 133 and the reliability of the semiconductor memory device 2 may be improved.

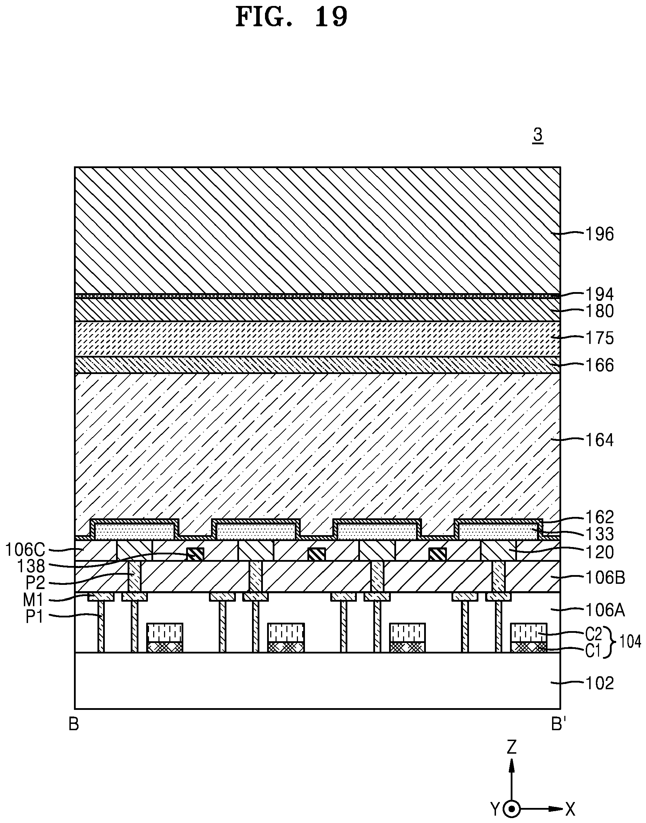

FIG. 19 is a cross-sectional view illustrating a semiconductor memory device 3 according to some embodiments. Hereinafter, the semiconductor memory device 3 illustrated in FIG. 19 is described, focusing mainly on the difference from the semiconductor memory device 1 described above with reference to FIGS. 1 to 2B.

Referring to FIG. 19, in the semiconductor memory device 3, a plurality of interfacial conductive patterns (131 of FIG. 2B) may be omitted, and each conductive line 120 may be in direct contact with the corresponding channel structure 133. In each channel structure 133, a horizontal channel portion (133H of FIG. 2A) may be in direct contact with the upper surface of the conductive line 120 and the upper surface of the interlayer insulating film 106C.

In the semiconductor memory device 3, the interfacial oxide semiconductor pattern 171 may have a relatively large contact area with the conductive contact pattern 173, thus, the total contact resistance formed between the channel structure 133 and the conductive contact pattern 173 may be reduced and accordingly, the reliability of a transistor including the channel structure 133 may be improved.

Embodiments have been described herein and illustrated in the drawings. Although the embodiments have been described herein by using specific terms, they are used only for the purpose of explaining the inventive concept and not used to limit the meaning or scope of the claims. Therefore, those of skill in the art will understand that various modifications and other equivalent embodiments may be derived from the embodiments described herein. Therefore, the true technical protection scope of the inventive concept should be determined by the appended claims.

While the inventive concepts have been particularly shown and described with reference to some examples of embodiments thereof, it will be understood that various changes in form and details may be made therein without departing from the scope of the following claims.

## Claims

1. A semiconductor memory device comprising:
a substrate;
a lower conductive line on the substrate;
an isolation insulating layer on the lower conductive line and comprising a channel trench;
a channel structure inside the channel trench and comprising a first oxide semiconductor material;
an interfacial conductive pattern between the lower conductive line and a lower surface of the channel structure;
a gate dielectric layer that covers the channel structure within the channel trench;
an upper conductive line on the gate dielectric layer within the channel trench;
a conductive contact pattern on the channel structure;
an interfacial oxide semiconductor pattern between the channel structure and the conductive contact pattern and comprising a second oxide semiconductor material; and
a capacitor structure comprising a lower electrode connected to the conductive contact pattern,
wherein a contact area between the interfacial conductive pattern and the channel structure is greater than a contact area between the interfacial conductive pattern and the lower conductive line, and
wherein a contact area between the interfacial oxide semiconductor pattern and the conductive contact pattern is greater than a contact area between the interfacial oxide semiconductor pattern and the channel structure.

2. The semiconductor memory device of claim 1, wherein the upper conductive line extends in a first direction,
wherein each of the lower conductive line and the interfacial conductive pattern extends in a second direction that intersects with the first direction, and
wherein a width of the interfacial conductive pattern in the first direction is greater than a width of the lower conductive line in the first direction.

3. The semiconductor memory device of claim 2, wherein a side surface of the interfacial conductive pattern and a side surface of the channel structure are vertically aligned with each other.

4. The semiconductor memory device of any preceding claim, wherein the interfacial conductive pattern and the lower conductive line include a same material.

5. The semiconductor memory device of any of claims 1-3, wherein a material of the interfacial conductive pattern and a material of the lower conductive line are different from each other.

6. The semiconductor memory device of any preceding claim, wherein the channel structure comprises:
a horizontal channel portion in direct contact with the interfacial conductive pattern; and
a vertical channel portion that extends in a vertical direction along a sidewall of the isolation insulating layer that defines the channel trench, and is in contact with the interfacial oxide semiconductor pattern.

7. The semiconductor memory device of claim 6, wherein the first oxide semiconductor material of the channel structure has a first composition, and
wherein the second oxide semiconductor material of the interfacial oxide semiconductor pattern has a second composition that is different from the first composition.

8. The semiconductor memory device of claim 7, wherein the second oxide semiconductor material comprises indium gallium zinc oxide, indium tin oxide, indium tungsten oxide, indium zinc oxide, indium gallium oxide, indium tin gallium oxide, indium gallium silicon oxide, or indium oxide, or a combination of two or more thereof.

9. The semiconductor memory device of claim 7 or claim 8, wherein an indium content of the second oxide semiconductor material is greater than an indium content of the first oxide semiconductor material.

10. The semiconductor memory device of any of claims 6-9, wherein the interfacial oxide semiconductor pattern comprises:
a lower pattern that extends along the sidewall of the isolation insulating layer and is in contact with a top of the channel structure; and
an upper pattern that is arranged on the lower pattern and in contact with an upper surface of the isolation insulating layer and the conductive contact pattern, and
wherein a width of the upper pattern is greater than a width of the lower pattern, in a second direction in which the lower conductive line extends.

11. The semiconductor memory device of claim 10, wherein a side surface of the upper pattern is vertically aligned with a side surface of the conductive contact pattern.

12. A semiconductor memory device comprising:
a substrate;
a conductive line on the substrate and extending in a first direction;
an interfacial conductive pattern extending in the first direction on the conductive line; and
a channel structure on the interfacial conductive pattern and comprising an oxide semiconductor material,
wherein a contact area between the interfacial conductive pattern and the channel structure is greater than a contact area between the interfacial conductive pattern and the conductive line.

13. The semiconductor memory device of claim 12, wherein the interfacial conductive pattern covers an entire upper surface of the conductive line.

14. The semiconductor memory device of claim 12 or claim 13, wherein the channel structure comprises:
a horizontal channel portion that is in direct contact with the interfacial conductive pattern and extends along an upper surface of the interfacial conductive pattern in a second direction that intersects with the first direction; and
a vertical channel portion extending in a vertical direction on the horizontal channel portion, and
wherein a width of the horizontal channel portion in the second direction is equal to a width of the interfacial conductive pattern in the second direction.

15. The semiconductor memory device of claim 14, wherein a side surface of the interfacial conductive pattern and a side surface of the channel structure are vertically aligned with each other.
